(19) Europäisches Patentamt
European Patent Office
Office européen des brevets

(11) EP 2 071 004 A1

(12) EUROPEAN PATENT APPLICATION
published in accordance with Art. 153(4) EPC

(43) Date of publication:
**17.06.2009 Bulletin 2009/25**

(21) Application number: **07828879.2**

(22) Date of filing: **21.09.2007**

(51) Int Cl.:
***C09K 11/06*** *(2006.01)* ***C08G 61/00*** *(2006.01)*
***H01L 33/00*** *(2006.01)* ***H01L 51/42*** *(2006.01)*

(86) International application number:
**PCT/JP2007/069138**

(87) International publication number:
**WO 2008/038814 (03.04.2008 Gazette 2008/14)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **26.09.2006 JP 2006260252**

(71) Applicant: **Sumitomo Chemical Company, Limited**
**Tokyo 104-8260 (JP)**

(72) Inventors:
- **TANAKA, Kenta**
  **Tsukuba-shi**
  **Ibaraki 305-0045 (JP)**
- **HIGASHIMURA, Hideyuki**
  **Tsukuba-shi**
  **Ibaraki 305-0045 (JP)**
- **TANAKA, Toshihiko**
  **Inashiki-gun**
  **Ibaraki 300-0331 (JP)**
- **TEMMA, Tomohisa**
  **Tsukuba-shi**
  **Ibaraki 305-0821 (JP)**
- **FUKUSHIMA, Daisuke**
  **Tsukuba-shi**
  **Ibaraki 305-0045 (JP)**

(74) Representative: **Duckworth, Timothy John**
**J.A. Kemp & Co.,**
**14 South Square,**
**Gray's Inn**
**London WC1R 5JJ (GB)**

# (54) POLYMERIC ADSORPTION FILMS AND PROCESSES FOR PRODUCING THESE

(57) The present invention provides a polymeric adsorption film comprising a polymer containing two or more charge-transport blocks and a substrate having the polymer thereon, wherein any of the charge-transport blocks is preferentially adhered to a surface of the substrate; a polymeric adsorption film comprising a polymer containing two or more charge-transport blocks and a substrate having the polymer thereon, wherein any of the charge-transport blocks different from the charge-transport block preferentially adhered to a surface of the substrate is preferentially exposed; or a polymeric adsorption film comprising a polymer and a substrate, wherein the polymer contains two or more charge-transport blocks and any charge-transport block selected from the charge-transport blocks is adhered to a surface of the substrate more preferentially than the other charge-transport blocks.

EP 2 071 004 A1

## Description

### Technical Field

The present invention relates to a polymeric adsorption film useful for an electronic device, a light-emitting diode, a photoelectric conversion device and the like and a process for producing the same.

### Background Art

A light-emitting material and a charge-transport material with a high molecular weight are soluble in a solvent and may be formed into a thin film by a convenient process such as a coating process. Therefore, there have been developed various polymeric compounds which are excellent as light-emitting materials and charge-transport materials.

However, when these polymers are used as light-emitting materials, charge-transport materials and the like, a large number of layers are generally laminated in order to enhance the performance of electronic devices to the level enough for practical use. For example, as such devices, there may be mentioned those obtained by laminating one or two kinds of charge-transport layers and light-emitting layers between electrodes (Description of U.S. Patent No. 6169163).

However, when a large number of layers are laminated, there occur several problems. There become required production equipment and time depending on the number of layers. In addition, there is a problem that a layer structure cannot be formed because a lower layer previously applied when laminating is dissolved. Accordingly, in general, the lower layer must be insoluble in a solvent used when an upper layer is applied and a limitation is imposed on the materials of the upper and lower layers. For example, as with the above example, the lower layer is required to be insolubilized by crosslinking and the like. Because of these problems, there is a fixed limitation on the structure of a molecule. There is a method of obtaining the same effect as lamination by mixing materials having different functions without laminating. However, the method is not always sufficient because it has a problem that the effect is insufficient and different kinds of materials are precipitated, and the like.

If a film is spontaneously and self-organizationally layer-separated into two or more layers in the laminating direction of a layer, two or more films may be formed by a single operation. Although there are known a large number of organic materials showing such phenomena, any of them has several problems when used for an electronic device. For example, these layers are required to have charge-transport properties and light-emitting properties.

As such an example, for example, A. Aviram et al. have proposed an idea that if the linearly bonded molecules are arranged between electrodes, a segment having an electron-releasing property and a segment having an electron-withdrawing property exhibit functions as a diode or of photoelectric conversion (Chemical Physics Letters, Vol. 29, No. 2, pp. 277-283).

Since then, several such molecules have been synthesized and the rectification is actually measured by asymmetrically attaching the molecules onto a substrate electrode. However, since the length of these molecules is extremely small, that is, in general, less than 3 nm, it is frequently extremely difficult to accurately produce such arrangement without any defects with good reproducibility. Therefore, such devices are difficult to produce industrially. For example, Yu et al. have used a scanning tunnel microscope to measure the rectification and it goes without saying that a device having a practical area is difficult to produce (Journal of American Chemical Society, Vol. 124, pp. 11862 - 11863).

On the contrary, a film, which is used in a laminated device of a light-emitting material, a charge-transport material and the like of the above polymer, is generally formed in a thickness of approximately 10 to 100 nm. Therefore, it is industrially meaningful to conveniently and rapidly form a multilayer structure corresponding to the film thickness of this film by some kind of a self-organizational process. For example, from the viewpoint of this concept, there is shown a process in which a laminated device having a light-emitting function is produced while linking p-type molecules with n-type molecules by a method of repeating condensation reaction on a substrate. Although this process is excellent in that the arrangement of p-type molecules and n-type molecules may be freely controlled, the reaction for lamination is required to be repeated many times in order to secure the film thickness required for the device. As a result, the process had a problem that the features capable of conveniently producing the device cannot be always accomplished. In addition, the yield of the each reaction is not always 100%, and it is likely to generate a segment in which the molecules cannot be linked in a planned order. Therefore, even though there is a possibility of obtaining a film of this structure in some part, it cannot be always said that the film of this structure is accurately and uniformly produced with good reproducibility in a fixed finite area in which the device is actually used (Japanese Patent Laid-Open No. 2006-32689).

If certain polymers containing a plurality of charge-transport blocks adhere to a substrate and one of the charge-transport blocks has a property of preferentially adhering onto the substrate, a layer mainly composed of the charge-transport block is formed on the substrate and a layer mainly composed of the other charge-transport block is formed at the opposite side to the substrate of the layer above. In addition, in this case, since the polymers have a large molecular weight, the thickness of each layer may be increased and may be produced by one adhering operation with good

reproducibility.

However, there has never been known a polymeric adsorption film, which comprises a polymer containing a plurality of charge-transport blocks having a charge transport property useful as an electronic device and has an asymmetric structure in which a specific charge-transport block is actually preferentially adhered to the substrate.

Consequently, as a result of earnest studies to obtain a polymeric adsorption film having an asymmetric structure in which a certain charge-transport block is preferentially adhered to a substrate, the present inventors have reached the present invention. The object of the present invention is to provide a polymeric adsorption film adhered to a solid surface useful for the production of an electronic device having a multilayer structure.

## Disclosure of the Invention

That is, the present invention provides the following (1) to (24):

(1) A polymeric adsorption film comprising a polymer containing two or more charge-transport blocks and a substrate having the polymer thereon, wherein any of the charge-transport blocks is preferentially adhered to a surface of the substrate.

(2) A polymeric adsorption film comprising a polymer containing two or more charge-transport blocks and a substrate having the polymer thereon, wherein any of charge-transport blocks different from the charge-transport blocks preferentially adhered to a surface of the substrate, is preferentially exposed.

(3) A polymeric adsorption film comprising a polymer and a substrate, wherein the polymer contains two or more charge-transport blocks and any charge-transport block selected from the charge-transport blocks is adhered to a surface of the substrate more preferentially than the other charge-transport blocks.

(4) The polymeric adsorption film described in any of (1) to (3), wherein the polymer satisfies the following equation:

$$Z_A > Z > (Z_A + Z_B)/2$$

wherein Z is a contact angle value of a film of the polymer shown above, $Z_A$ is the largest value of the contact angle of a film of a polymer comprising one charge-transport block possessed by the polymer referred in the definition of Z, and $Z_B$ is the smallest value of the contact angle.

(5) The polymeric adsorption film described in any of (1) to (3), wherein the polymer comprises two or more charge-transport blocks and satisfies the following equation:

$$Z_B < Z < (Z_A + Z_B)/2$$

wherein Z is a contact angle value of a film of the polymer shown above, $Z_A$ is the largest value of the contact angle of a film of a polymer comprising one charge-transport block possessed by the polymer referred in the definition of Z, and $Z_B$ is the smallest value of the contact angle.

(6) The polymeric adsorption film described in any of (1) to (5), wherein the polymer has a number average molecular weight in terms of polystyrene of $10^3$ or more and $10^8$ or less.

(7) The polymeric adsorption film described in any of (1) to (6), wherein at least one of the charge-transport blocks possessed by the polymer has a light-emitting property.

(8) The polymeric adsorption film described in any of (1) to (7), wherein at least one of the charge-transport blocks possessed by the polymer has an electron-transport property and at least one of the charge-transport blocks has a hole-transport property.

(9) The polymeric adsorption film described in any of (1) to (8), wherein the polymer is an asymmetric block copolymer.

(10) The polymeric adsorption film described in any of (1) to (9), wherein at least one of the charge-transport blocks is a polyarylene residue.

(11) The polymeric adsorption film described in any of (1) to (10), wherein at least one of the charge-transport blocks is an aromatic polyamine residue.

(12) The polymeric adsorption film described in (11), wherein a concentration by weight of a nitrogen atom contained in the polymer is 1% or more.

(13) The polymeric adsorption film described in any of (10) to (12), wherein at least one of the charge-transport blocks is a polyarylene residue and at least one of the charge-transport blocks is an aromatic polyamine residue.

(14) The polymeric adsorption film described in any of (10) to (13), wherein the polyarylene residue is a polyfluorene-diyl group which may have a substituent or a polybenzofluorene-diyl group which may have a substituent.
(15) The polymeric adsorption film described in any of (9) to (14), wherein the asymmetric block copolymer comprises a segment (A) comprising one or two or more hole-transport blocks and a segment (B) comprising one or two or more electron-transport blocks which are directly or indirectly linked to the segment (A).
(16) The polymeric adsorption film described in any of (9) to (15), wherein the asymmetric block copolymer has a structure represented by the following formula (1):

$$\cdots\left(Ar^{11}\right)_{m^{11}}\cdots\left(Ar^{12}\right)_{m^{12}}\cdots\left(Ar^{13}\right)_{m^{13}}\cdots\ \cdot\cdot\cdot\ \cdots\left(Ar^{n}\right)_{m^{n}}\cdots \qquad (1)$$

wherein $Ar^{11}$, $Ar^{12}$, $Ar^{13}$,..., and $Ar^{n}$ (n is an integer of 12 or more) each independently represent a divalent conjugated group which may have a substituent in one charge-transport block, provided that the charge-transport blocks may be directly bonded together or may be bonded via a bonding group, and when the charge-transport blocks are directly bonded together, the divalent conjugated group constituting two charge-transport blocks which are directly bonded are different each other; $m^{11}$, $m^{12}$, $m^{13}$,..., $m^{n}$ are each independently an integer of 5 or more.
(17) The polymeric adsorption film described in (16), wherein the asymmetric block copolymer is represented by the following formula (6):

$$R^{X}-\left(Ar^{1}\right)_{m^{1}}-\left(Ar^{2}\right)_{m^{2}}-\left(Ar^{3}\right)_{m^{3}}-R^{Y} \qquad (6)$$

wherein $Ar^1$, $Ar^2$ and $Ar^3$ each independently represent a divalent conjugated group which may have a substituent, provided that $Ar^1$ and $Ar^2$ are different and $Ar^2$ and $Ar^3$ are different; $R^X$ and $R^Y$ each independently represent a terminal group; $m^1$, $m^2$ and $m^3$ are each independently an integer of 0 or more, provided that at least two of $m^1$, $m^2$ and $m^3$ are an integer of 5 or more; when $Ar^2$ has an adhesion group, $R^X$, $R^Y$, $Ar^1$ and $Ar^3$ have no adhesion groups; when $Ar^2$ has no adhesion groups, either one of $Ar^1$ or $R^X$ and either one of $Ar^3$ or $R^Y$ have an adhesion group.
(18) The polymeric adsorption film described in (17), wherein the asymmetric block copolymer is represented by the following formula (7):

$$R^{P}-\left(Ar^{4}\right)_{m^{4}}-\left(Ar^{5}\right)_{m^{5}}-R^{Q} \qquad (7)$$

wherein $Ar^4$ and $Ar^5$ each independently represent a divalent conjugated group which may have a substituent, provided that $Ar^4$ and $Ar^5$ are different; $R^P$ and $R^Q$ each independently represent a terminal group; $m^4$ and $m^5$ each independently are an integer of 5 or more; $Ar^4$, $R^P$, $Ar^5$ or $R^Q$ has an adhesion group.
(19) The polymeric adsorption film described in (18), wherein the $Ar^4$ is a polyarylene residue which may have a substituent and the $Ar^5$ is an aromatic polyamine residue which may have a substituent.
(20) The polymeric adsorption film described in (19), wherein the polyarylene residue is a polyfluorene-diyl group which may have a substituent or a polybenzofluorene-diyl group which may have a substituent.
(21) A process for producing the polymeric adsorption film described in any of (1) to (20) comprising a step of immersing the substrate in a solution of the polymer.
(22) A process for producing the polymeric adsorption film described in any of (1) to (20) comprising a step of applying a solution of the polymer to the substrate.
(23) A process for producing the polymeric adsorption film described in (21) or (22) comprising a step of immersing or applying a solution of the polymer to the substrate and then bringing the polymer into contact with a good solvent of the polymer..
(24) A polymeric adsorption film obtained by the process for producing a polymeric adsorption film described in any of (21) to (23).
(25) An electronic device containing the polymeric adsorption film described in (1) to (20) and (24).
(26) A light-emitting diode comprising the electronic device described in (25).
(27) A photoelectric conversion device comprising the electronic device described in (25).

## Brief Description of the Drawings

Figure 1 shows fluorescence spectra of a glass substrate (a polymeric adsorption film) prepared-in Example 1 and a glass substrate (a polymeric film) prepared in Comparative Example 1; and
Figure 2 shows fluorescence spectra of glass substrates (polymeric adsorption films) prepared in Examples 3 to 5.

## Best Modes for Carrying Out the Invention

Hereinafter, the present invention will be described in detail.

<Polymeric Adsorption Film>

A polymeric adsorption film of the present invention is the following three kinds.

1. A polymeric adsorption film in which a polymer containing two or more charge-transport blocks is adhered onto a substrate, wherein any of the charge-transport blocks is preferentially adhered to a surface of the substrate.
2. A polymeric adsorption film in which a polymer containing two or more charge-transport blocks is adhered onto a substrate, wherein any of charge-transport blocks different from the charge-transport block preferentially adhered to a surface of the substrate is preferentially exposed.
3. A polymeric adsorption film in which a polymer is adhered onto a substrate, wherein the polymer contains two or more charge-transport blocks and any charge-transport block selected from the charge-transport blocks is adhered to a surface of the substrate more preferentially than the other charge-transport blocks.

Here, the phrase "preferentially adhered to a surface of the substrate" means that some of charge-transport blocks are contacted with a substrate more preferentially than the other blocks. For example, it means that the space occupied by a block present in a space near a surface of the substrate (usually within 1 nm from the substrate uppermost surface) is larger than a space occupied by other blocks. In addition, the term "adsorption" usually means a phenomenon in which when two different uniform phases exist, the composition differs from the composition in each uniform phase in the boundary region. In the case of the present invention, it means a phenomenon in which when a phase of a solution containing a polymer and the like is contacted with a substrate, a region where the concentration of the polymer is different from the concentration in the bulk is formed on a surface of the substrate. The polymeric adsorption film of the present invention corresponds to the region. The term "preferentially" as used in the present description means that a space, surface or quantity or the like occupied by any of compositions is larger than that occupied by the other compositions. For example, it means that a space occupied by the charge-transport block A exceeds 50%. The term "exposure" as used in the present description means a state where the property of a space near the film surface (usually within 1 nm from the uppermost surface of the film) of the polymeric adsorption film adhered to a surface of the substrate is close to the property of the charge-transport block different from the charge-transport block adhered. The property includes, for example, contact angle, color tone, hardness, heat resistance, water resistance, adsorption property, solvent resistance, electric conductivity, light-emitting property and light absorption property.

The polymeric adsorption film of the present invention preferably satisfies any of the following equations, wherein the polymer comprises two or more charge-transport blocks:

$$Z_A > Z > (Z_A + Z_B)/2 \qquad (A)$$

$$Z_B < Z < (Z_A + Z_B)/2 \qquad (B)$$

wherein Z is the contact angle value of a film of the polymer shown above, $Z_A$ is the largest value of the contact angle of a film of a polymer comprising one charge-transport block possessed by the polymer referred in the definition of Z, and $Z_B$ is the smallest value of the contact angle.

When a droplet is in contact with a solid surface, the contact angle is the angle between the liquid surface and the solid surface, and defined as the angle at the side containing the liquid. In the present invention, when a polymeric adsorption film or a spin-coated film described later is in contact with ultrapure water, the contact angle is defined as

the angle at the side of the ultrapure water. Here, the term "water repellency" means that the angle at the side of the ultrapure water is 50° or more, and the term "hydrophilicity" means that the angle at the side of the ultrapure water is less than 50°.

Here, a film, which has the largest value among the contact angles of a film of a polymer comprising one of charge-transport blocks, is water repellent, and a film having the smallest value is hydrophilic. When the polymeric adsorption film of the present invention satisfies the above equation (A), since it is notably shown that the charge-transport block constituting the film having the largest value of the contact angle is preferentially exposed, preferred is $Z_A - Z < 30°$, more preferred is $Z_A - Z < 20°$ and further more preferred is $Z_A - Z < 10°$. In addition, when the polymeric adsorption film of the present invention satisfies the above equation (B), since it is notably shown that the charge-transport block constituting the film having the smallest value of the contact angle is preferentially exposed, preferred is $Z - Z_B < 30°$, more preferred is $Z - Z_B < 20°$ and further more preferred is $Z - Z_B < 10°$.

- Substrate -

The substrate represents a solid to which a polymeric adsorption film is adhered, and as the material, there may be used one which is well known in the electronics industry field, in the display field and the like, depending on the applications. The specific examples include glass, sapphire, semiconductors (for example, silicon), resins, base metals, noble metals (for example, platinum, gold, palladium), oxides (for example, silicon oxide, indium tin oxide, tin oxide, titanium oxide, molybdenum oxide, tungsten oxide, tantalum oxide and aluminum oxide), nitrides (for example, silicon nitride and gallium nitride) and carbides (for example, silicon carbide). These materials of the substrate may be used alone or in combination with two or more kinds. For example, there may be used a material of the uppermost surface layer of a substrate which is different from the inside. Specifically, there may be mentioned one in which a layer of an indium tin oxide is installed on a glass plate and the like. In addition, when the substrate comprises two or more materials, the material constituting the uppermost surface layer of the substrate is adhered to the polymeric adsorption film. For the uppermost surface layer, there is preferably used a material which is physically and chemically stable. The shape of the substrate is generally preferably flat and smooth and has a thickness of preferably from 1 μm to 1 m, more preferably from 0.01 mm to 100 mm and especially preferable from 0.1 mm to 10 mm.

- Polymeric Adsorption Film -

A polymeric adsorption film contains a thin film comprising a polymer described later which is formed on the substrate and the substrate. The thin film has an average thickness of usually from 0.1 nm to 10 μm, preferably from 0.2 nm to 1 μm, more preferably from 0.2 nm to 500 nm and further more preferably from 0.2 nm to 200 nm. The charge-transport block, which is preferentially adhered to a substrate, is preferably in contact with the other charge-transport blocks by various interactions (binding force such as van der Waals force, ionic bond and hydrogen bond).

- Polymer -

The polymer used for the polymeric adsorption film of the present invention will be described. In the present invention, the polymer contains two or more charge-transport blocks. Here, the term "the charge-transport block" means to have a charge-transport property and is a unit of a structure having an almost constant physical and chemical property of the same nature in a polymer. In addition, the term "the block" generally means a molecular structure (segment) constructed by five or more constitutional units. A variety of specific molecular structures may be used for such constitutional units, and preferred is a molecular structure in which repeating units are linked and more preferred is a molecular structure in which five or more repeating units are linked.

In general, if the polymer has a too small molecular weight, it may not form a polymeric adsorption film with good reproducibility in many cases. In addition, if the polymer has a too large molecular weight, it is hardly dissolved and is difficult to use in many cases. Therefore, the polymer has a number average molecular weight in terms of polystyrene of preferably $10^3$ or more, more preferably $10^3$ or more and $10^8$ or less and especially preferably $5 \times 10^3$ or more and $10^7$ or less.

Such a charge-transport block includes a structure in which a well-known divalent charge-transport group Ar is linked. When linking the well-known charge-transport group Ar, each charge-transport group Ar may be independently selected. However, from the viewpoint of easiness of synthesis of a polymer, the kind of the charge-transport group Ar constituting these blocks is preferably small, more preferably 5 kinds or less, further more preferably 2 kinds or less and especially preferably one kind. In this case, the bonding order of plural kinds of the charge-transport groups Ar ($Ar^1$, $Ar^2$, $Ar^3$,...) in the same block is not particularly limited and may be selected accordingly depending on the purpose; and, from the viewpoint of easiness of synthesis, random bonding or alternating bonding (in case of two kinds) is preferable.

As the charge-transport group Ar, there may be mentioned, for example, a group which is known as a repeating

unit of a well-known conjugated polymer or a divalent group derived from a well-known charge-transport compound. As the charge-transport group Ar, there may be specifically used a group exemplified below. Among these, from the viewpoint of stability, easiness of synthesis, charge transportation and the like, preferred are divalent groups represented by (C-1) to (C-20), (D-1) to (D-19), (E-1) to (E-2), (E-7) to (E-13), (E-15) to (E-20), (E-22) to (E-26), (G-1) to (G-8), (J-1) to (J-3), (J-5) to (J-14) and (J-18) to (J-22), more preferred are divalent groups represented by (C-1) to (C-6), (C-10), (C-11), (C-15), (D-19), (D-20), (E-17) to (E-20), (G-1) to (G-8) and (J-1) to (J-3), further more preferred are divalent groups represented by (C-1) to (C-3), (C-10), (C-11), (C-15), (D-16) to (D-19), (E-17) to (E-20) and (G-1) to (G-6), and especially preferred are divalent groups represented by (C-1), (C-11), (C-15), (D-16), (E-20), (G-1) and (G-2). In addition, if the divalent group is used for each electronic device having a light-emitting function, at least one of the charge-transport blocks preferably has a light-emitting property. As such a charge-transport block having a light-emitting property, there may be mentioned a group which is known as a repeating unit of a polymer showing a well-known light-emitting property or a divalent group derived from a well-known fluorescent or phosphorescent compound. As such a charge-transport block having a light-emitting property, from the viewpoint of easiness of synthesis, charge transportation and the like, an illustrative group below may be selected and used accordingly depending on the purpose. For example, (C-1), (C-11), (C-15), (D-16) and (E-20) may be preferably used.

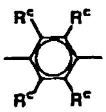
(C-1)

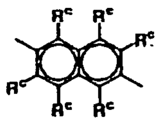
(C-2)

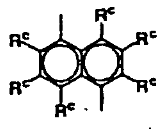
(C-3)

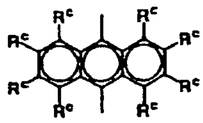
(C-4)

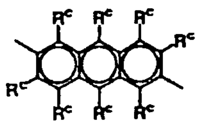
(C-5)

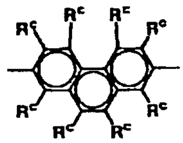
(C-6)

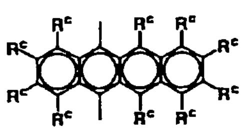
(C-7)

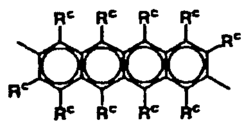
(C-8)

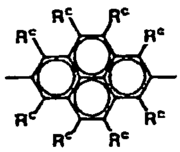
(C-9)

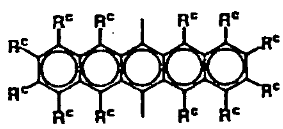
(C-10)

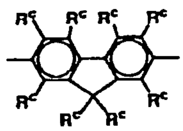
(C-11)

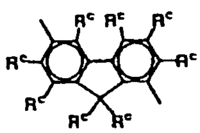
(C-12)

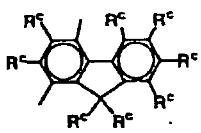
(C-13)

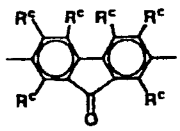
(C-14)

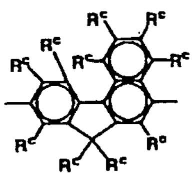
(C-15)

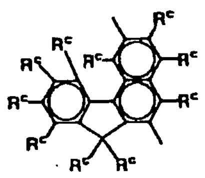
(C-16)

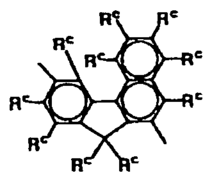
(C-17)

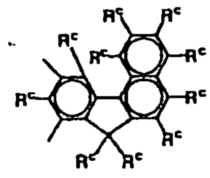
(C-18)

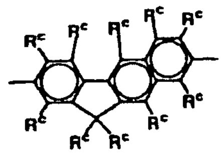
(C-19)

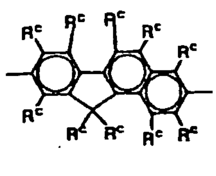
(C-20)

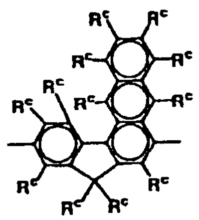
(C-21)

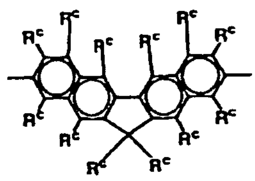
(C-22)

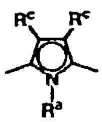
(D-1)

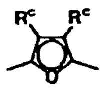
(D-2)

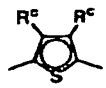
(D-3)

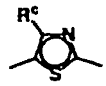
(D-4)

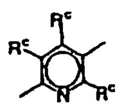
(D-5)

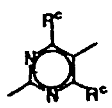
(D-6)

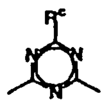
(D-7)

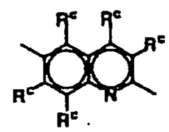
(D-8)

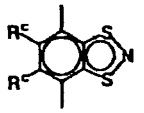
(D-9)

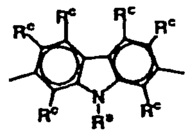
(D-10)

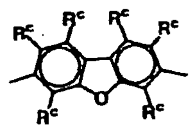
(D-11)

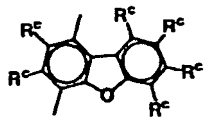
(D-12)

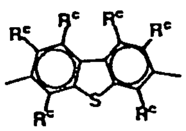
(D-13)

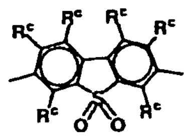
(D-14)

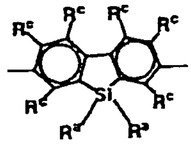
(D-15)

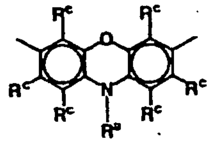
(D-16)

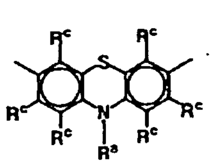

(D-17)

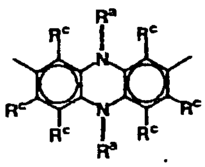

(D-18)

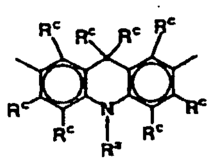

(D-19)

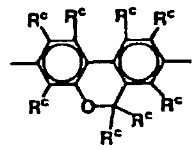

(D-20)

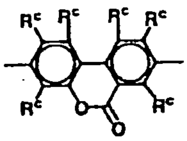

(D-21)

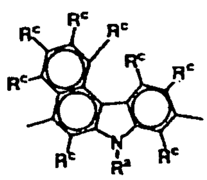

(D-22)

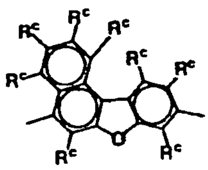

(D-23)

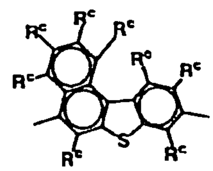

(D-24)

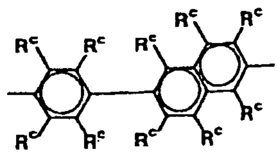

(E-1)

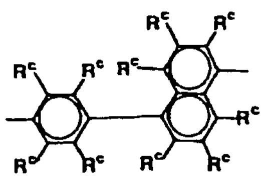

(E-2)

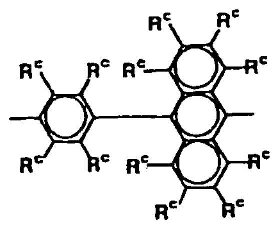

(E-3)

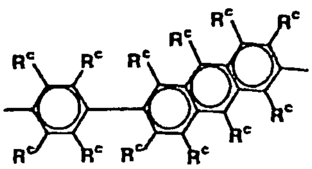

(E-4)

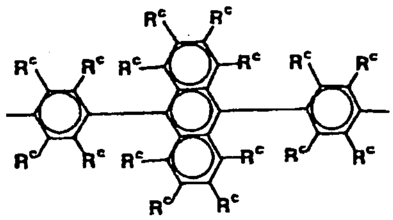

(E-5)

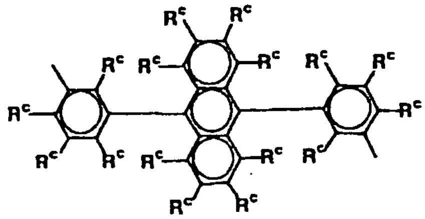

(E-6)

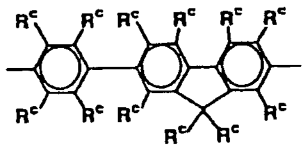

(E−7)

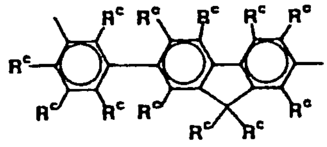

(E−8)

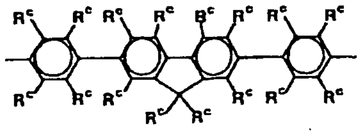

(E−9)

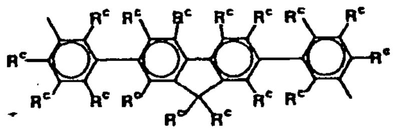

(E−10)

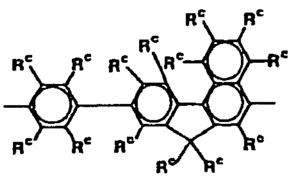

(E−11)

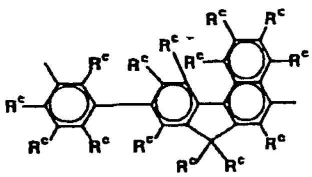

(E−12)

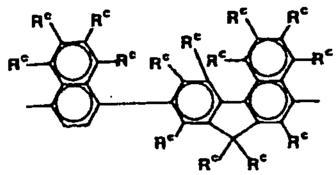

(E−13)

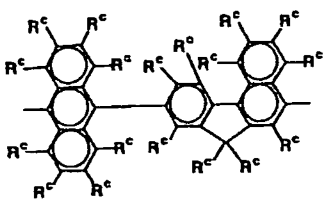

(E−14)

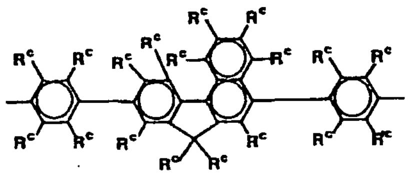

(E−15)

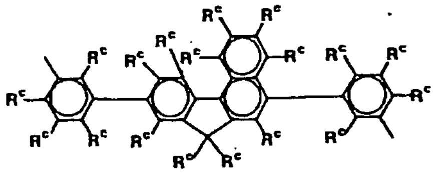

(E−16)

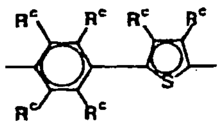

(E-17)

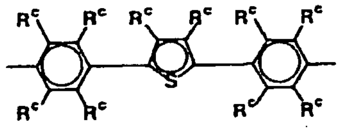

(E-18)

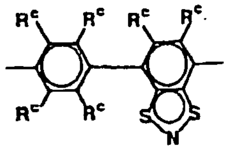

(E-19)

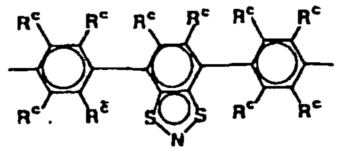

(E-20)

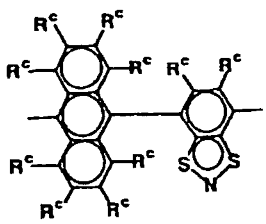

(E-21)

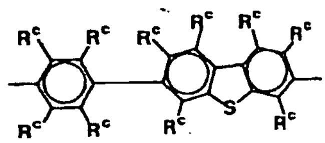

(E-22)

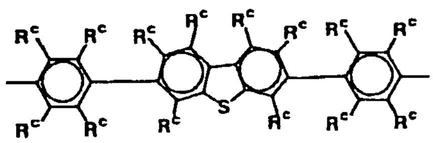

(E-23)

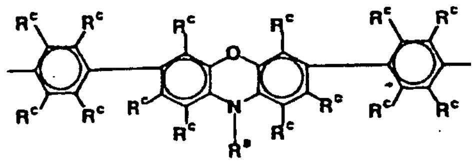

(E-24)

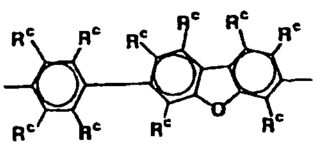

(E-25)

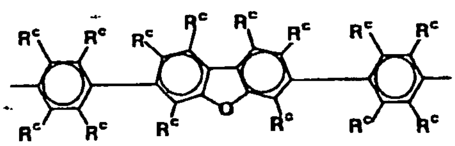

(E-26)

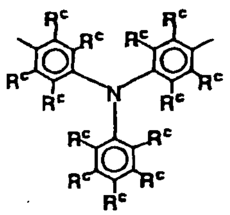

(G-1)

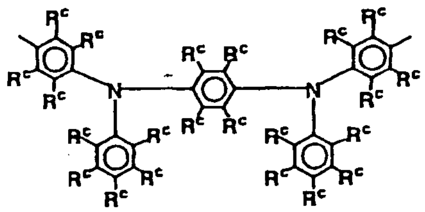

(G-2)

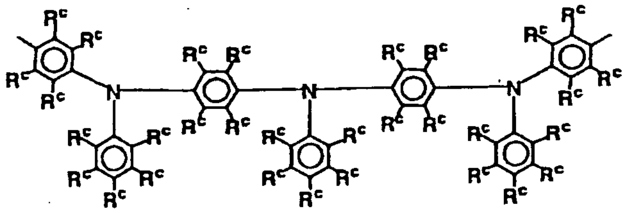

(G-3)

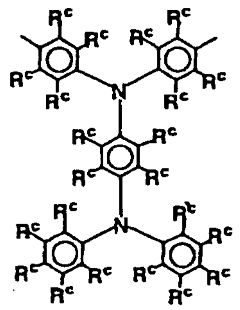

(G-4)

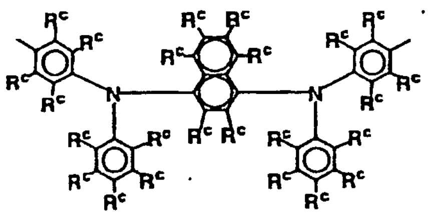

(G-5)

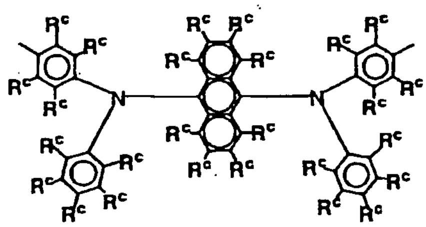

(G-6)

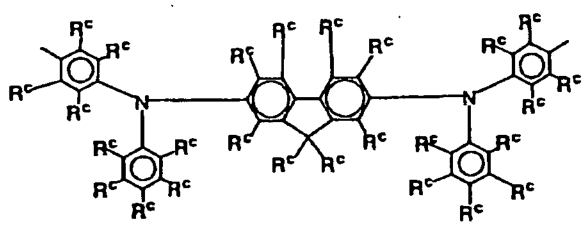

(G-7)

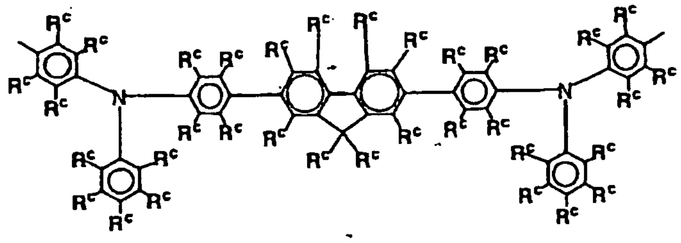

(G-8)

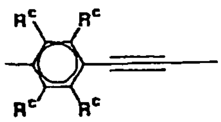

(J-1)

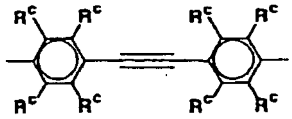

(J-2)

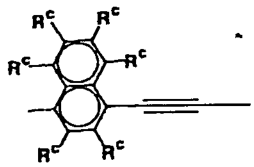

(J-3)

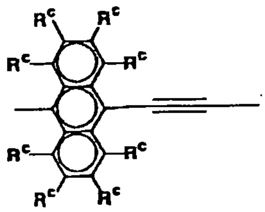

(J-4)

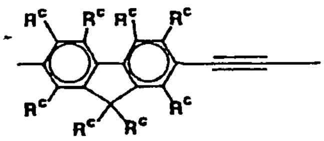

(J-5)

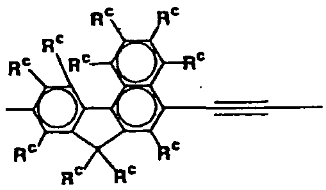

(J-6)

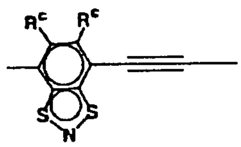

(J-7)

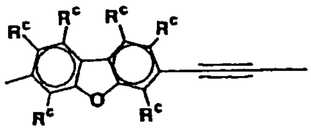

(J-8)

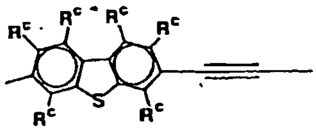

(J-9)

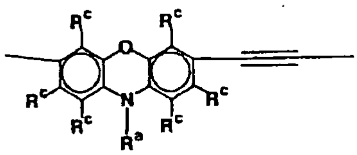

(J-10)

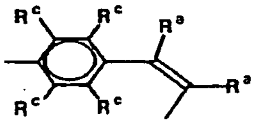

(J-11)

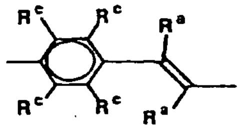

(J-12)

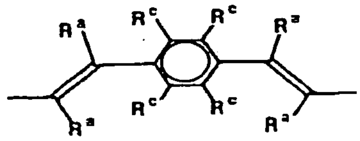

(J-13)

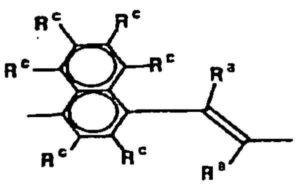

(J-14)

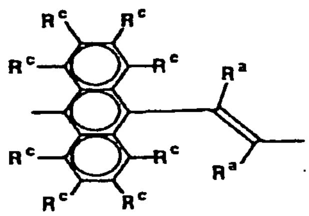

(J-15)

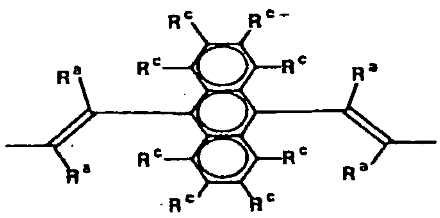

(J-16)

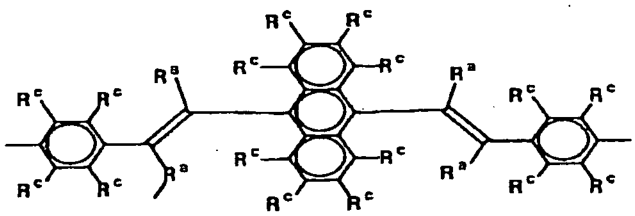

(J-17)

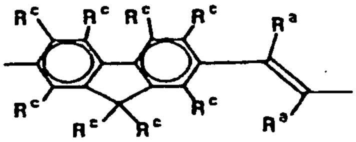

(J-18)

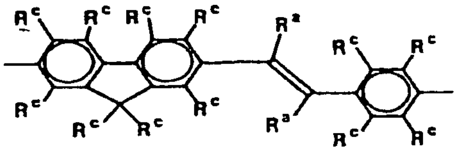

(J-19)

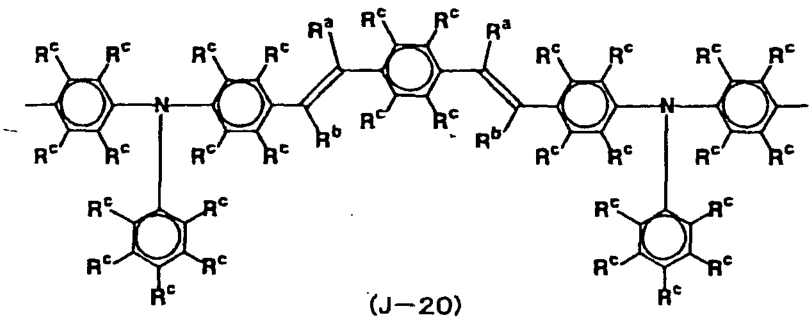

(J-20)

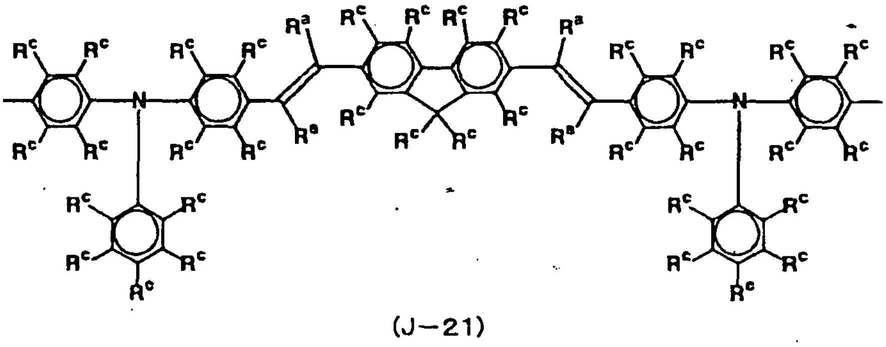

(J-21)

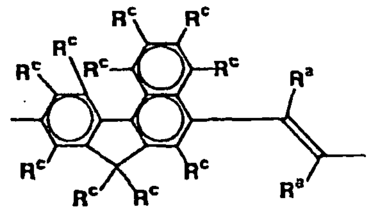

(J−22)

In the Table, $R^a$ represents a hydrogen atom or a substituent, and from the viewpoint of stability, easiness of synthesis and the like, preferred are a hydrogen atom, an alkyl group, an aryl group, an arylalkyl group and a monovalent heterocyclic group, and more preferred are an alkyl group, an aryl group, an arylalkyl group and a monovalent heterocyclic group, and further more preferred are an alkyl group and an aryl group.

Here, the alkyl group may be linear, branched or cyclic, and has a carbon number of generally from 1 to 20, preferably from 1 to 15 and more preferably from 1 to 10. The specific examples include a methyl group, an ethyl group, a propyl group, an i-propyl group, a butyl group, an i-butyl group, a t-butyl group, a pentyl group, an isoamyl group, a hexyl group, a cyclohexyl group, a heptyl group, an octyl group, a 2-ethylhexyl group, a nonyl group, a decyl group, a 3,7-dimethyloctyl group, a lauryl group, a 1-adamantyl group, a 2-adamantyl group, a trifluoromethyl group, a pentafluoroethyl group, a perfluorobutyl group, a perfluorohexyl group and a perfluorooctyl group, and from the viewpoint of the balance between easiness of synthesis, etc, and heat resistance, preferred are a methyl group, an ethyl group, a propyl group, an i-propyl group, a butyl group, an i-butyl group, a t-butyl group, a pentyl group, an isoamyl group, a hexyl group, an octyl group, a 2-ethylhexyl group, a decyl group and a 3,7-dimethyloctyl group. If a plurality of $R^a$s are present, two alkyl groups may be bonded together to form a ring.

The aryl group is an atom group in which a hydrogen atom is removed from an aromatic hydrocarbon, and includes an aryl group having a condensed ring and an aryl group in which two or more independent benzene rings or condensed rings are bonded directly or via a group such as vinylene. The aryl group has a total carbon number of generally from 6 to 60 and preferably from 7 to 48. The specific examples include a phenyl group, a 1-naphthyl group, a 2-naphthyl group, a 1-anthracenyl group, a 2-anthracenyl group, a 9-anthracenyl group and a pentafluorophenyl group, which may further contain a substituent such as an alkyl group, an alkoxy group, an alkyloxycarbonyl group and a substituted amino group. From the viewpoint of solubility in an organic solvent, easiness of synthesis and the like, preferred is a phenyl group having one or more alkyl groups having 1 to 20 carbon atoms and/or alkoxy groups and/or alkyloxycarbonyl groups having 1 to 12 carbon atoms as a substituent.

The arylalkyl group has a- carbon number of generally from approximately 7 to 60 and preferably from 7 to 48. The specific examples include a phenyl-$C_1$ to $C_{12}$ alkyl group, a $C_1$ to $C_{12}$ alkoxyphenyl-$C_1$ to $C_{12}$ alkyl group, a $C_1$ to $C_{12}$ alkylphenyl-$C_1$ to $C_{12}$ alkyl group, a 1-naphthyl-$C_1$ to $C_{12}$ alkyl group and a 2-naphthyl-$C_1$ to $C_{12}$ alkyl group. From the viewpoint of solubility in an organic solvent, easiness of synthesis and the like, preferred are a $C_1$ to $C_{12}$ alkoxyphenyl-$C_1$ to $C_{12}$ alkyl group and a $C_1$ to $C_{12}$ alkylphenyl-$C_1$ to $C_{12}$ alkyl group.

The monovalent heterocyclic group means an atomic group in which a hydrogen atom is removed from a heterocyclic compound, and has a carbon number of generally from approximately 4 to 60 and preferably from 4 to 20. In addition, the carbon number of a substituent is not included in the carbon number of the heterocyclic compound. The heterocyclic compound referred to here is an organic compound with a ring structure in which the elements constituting a ring include not only a carbon atom but also heteroatoms such as oxygen, sulfur, nitrogen, phosphorus and boron in the ring. Specific examples include a thienyl group, a $C_1$ to $C_{12}$ alkylthienyl group, a pyrrolyl group, a furyl group, a pyridyl group, a $C_1$ to $C_{12}$ alkylpyridyl group, a piperidyl group, a quinolyl group and an isoquinolyl group, and preferred are a thienyl group, a $C_1$ to $C_{12}$ alkylthienyl group, a pyridyl group and a $C_1$ to $C_{12}$ alkylpyridyl group.

In the Table, $R^c$ each independently represent a hydrogen atom or substituent, and preferably, the substituent is selected from an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, substituted silyl group, a halogen atom, an acyl group, an acyloxy group, an amide group, an imide residue, a monovalent heterocyclic group, a carboxyl group, a substituted carboxyl group and a cyano group; more preferably it is selected from an alkyl group, an alkoxy group, an aryl group, an aryloxy group, an

arylalkyl group, an arylalkoxy group, a substituted amino group, a substituted silyl group, an acyl group, a substituted carboxyl group and a cyano group; further more preferably, it is selected from an alkyl group, an alkoxy group, an aryl group, an aryloxy group, an arylalkyl group, an arylalkoxy group and a substituted carboxyl group; still further more preferably is selected from an alkyl group, an alkoxy group and an aryl group; and especially preferably it is an alkyl group.

The alkyl group referred to here may be linear, branched or cyclic, and has a carbon number of generally from approximately 1 to 20, preferably from 1 to 15 and more preferably from 1 to 10. The specific examples include a methyl group, an ethyl group, a propyl group, an i-propyl group, a butyl group, an i-butyl group, a t-butyl group, a pentyl group, an isoamyl group, a hexyl group, a cyclohexyl group, a heptyl group, an octyl group, a 2-ethylhexyl group, a nonyl group, a decyl group, a 3,7-dimethyloctyl group, a lauryl group, a 1-adamantyl group, a 2-adamantyl group, a trifluoromethyl group, a pentafluoroethyl group, a perfluorobutyl group, a perfluorohexyl group and a perfluorooctyl group, and from the viewpoint of the balance between easiness of synthesis, etc. and heat resistance, preferred are a methyl group, an ethyl group, a propyl group, an i-propyl group, a butyl group, an i-butyl group, a t-butyl group, a pentyl group, an isoamyl group, a hexyl group, an octyl group, a 2-ethylhexyl group, a decyl group and a 3,7-dimethyloctyl group. If a plurality of alkyl groups are present, two alkyl groups may be bonded together to form a ring.

The alkoxy group may be linear, branched or cyclic, and has a carbon number of generally from approximately 1 to 20 and preferably from 1 to 15. The specific examples include a methoxy group, an ethoxy group, a propyloxy group, an i-propyloxy group, a butoxy group, an i-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a lauryloxy group, a trifluoromethoxy group, a pentafluoroethoxy group, a perfluorobutoxy group, a perfluorohexyl group, a perfluorooctyl group, a methoxymethyloxy group, a 2-methoxyethyloxy group and a 2-ethoxyethyloxy group, and from the viewpoint of the balance between solubility in organic solvents, easiness of synthesis, etc. and heat resistance, preferred are a pentyloxy group, a hexyloxy group, an octyloxy group, a 2-ethylhexyloxy group, a decyloxy group and a 3,7-dimethyloctyloxy group.

The alkylthio group may be linear, branched or cyclic, and has a carbon number of generally from approximately 1 to 20 and preferably from 3 to 20.

The aryl group is an atom group in which a hydrogen atom is removed from an aromatic hydrocarbon, and includes an aryl group having a condensed ring and an aryl group in which two or more independent benzene rings or condensed rings are bonded directly or via a group such as vinylene. The aryl group has a total carbon number of generally from 6 to 60 and preferably from 7 to 48. The specific examples include a phenyl group, a 1-naphthyl group, a 2-naphthyl group, a 1-anthracenyl group, a 2-anthracenyl group, a 9-anthracenyl group and a pentafluorophenyl group, which may further contain a substituent such as an alkyl group, an alkoxy group and alkyloxycarbonyl group.

The aryloxy group has a carbon number of generally from approximately 6 to 60 and preferably from 7 to 48. The specific examples include a phenoxy group, a $C_1$ to $C_{12}$ alkoxyphenoxy group ($C_1$ to $C_{12}$ represents that the carbon number is 1 to 12, to be used in the same meaning hereinafter), a $C_1$ to $C_{12}$ alkylphenoxy group, a 1-naphthyloxy group, a 2-naphthyloxy group and a pentafluorophenyloxy group, and from the viewpoint of solubility in an organic solvent, easiness of synthesis and the like, preferred are a $C_1$ to $C_{12}$ alkoxyphenoxy group and a $C_1$ to $C_{12}$ alkylphenoxy group.

The arylthio group has a carbon number of generally from approximately 3 to 60, and the specific examples include a phenylthio group, a $C_1$ to $C_{12}$ alkoxyphenylthio group, a $C_1$ to $C_{12}$ alkylphenylthio group, a 1-naphthylthio group, 2-naphthylthio group and a pentafluorophenylthio group.

The arylalkyl group has a carbon number of generally from approximately 7 to 60 and preferably from 7 to 48. The specific examples include a phenyl-$C_1$ to $C_{12}$ alkyl group, a $C_1$ to $C_{12}$ alkoxyphenyl-$C_1$ to $C_{12}$ alkyl group, a $C_1$ to $C_{12}$ alkylphenyl-$C_1$ to $C_{12}$ alkyl group, a 1-naphthyl-$C_1$ to $C_{12}$ alkyl group and a 2-naphthyl-$C_1$ to $C_{12}$ alkyl group.

The arylalkoxy group has a carbon number of generally from approximately 7 to 60 and preferably from 7 to 48. The specific examples include a phenyl-$C_1$ to $C_{12}$ alkoxy group such as a phenylmethoxy group, a phenylethoxy group, a phenylbutoxy group, a phenylpentyloxy group, a phenylhexyloxy group, a phenylheptyloxy group and a phenyloctyloxy group, a $C_1$ to $C_{12}$ alkoxyphenyl-$C_1$ to $C_{12}$ alkoxy group, a $C_1$ to $C_{12}$ alkylphenyl-$C_1$ to $C_{12}$ alkoxy group, a 1-naphthyl-$C_1$ to $C_{12}$ alkoxy group and a 2-naphthyl-$C_1$ to $C_{12}$ alkoxy group.

The arylalkylthio group has a carbon number of generally from approximately 7 to 60 and preferably from 7 to 48.

The arylalkenyl group has a carbon number of generally from approximately 8 to 60, and the specific examples include a phenyl-$C_2$ to $C_{12}$ alkenyl group, a $C_1$ to $C_{12}$ alkoxyphenyl-$C_2$ to $C_{12}$ alkenyl group, a $C_1$ to $C_{12}$ alkylphenyl-$C_2$ to $C_{12}$ alkenyl group, a 1-naphthyl-$C_2$ to $C_{12}$ alkenyl group and a 2-naphthyl-$C_2$ to $C_{12}$ alkenyl group.

The arylalkynyl group has a carbon number of generally from approximately 8 to 60, and the specific examples include a phenyl-$C_2$ to $C_{12}$ alkynyl group, a $C_1$ to $C_{12}$ alkoxyphenyl-$C_2$ to $C_{12}$ alkynyl group, a $C_1$ to $C_{12}$ alkylphenyl-$C_2$ to $C_{12}$ alkynyl group, a 1-naphthyl-$C_2$ to $C_{12}$ alkynyl group and a 2-naphthyl-$C_2$ to $C_{12}$ alkynyl group.

The substituted amino group includes an amino group which is substituted by one or two groups selected from an alkyl group, an aryl group, an arylalkyl group or a monovalent heterocyclic group, which may have a substituent. The substituted amino group has a carbon number of generally from approximately 1 to 60 and preferably from 2 to 48 not including the carbon number of the substituent. The specific examples include a methylamino group, a dimethylamino

group, an ethylamino group, a diethylamino group, a propylamino group, a dipropylamino group, an i-propylamino group, a diisopropylamino group, a butylamino group, an i-butylamino group, a t-butylamino group, a pentylamino group, a hexylamino group, a cyclohexylamino group, a heptylamino group, an octylamino group, a 2-ethylhexylamino group, a nonylamino group, a decylamino group, a 3,7-dimethyloctylamino group, a laurylamino group, a cyclopentylamino group, a dicyclopentylamino group, a cyclohexylamino group, a dicyclohexylamino group, a pyrrolidyl group, a piperidyl group, a ditrifluoromethylamino group, a phenylamino group, a diphenylamino group, a $C_1$ to $C_{12}$ alkoxyphenylamino group, a di($C_1$ to $C_{12}$ alkoxyphenyl)amino group, a di($C_1$ to $C_{12}$ alkylphenyl)amino group, a 1-naphthylamino group, a 2-naphthylamino group, a pentafluorophenylamino group, a pyridylamino group, a pyridazinylamino group, a pyrimidylamino group, a pyrazylamino group, a triazylamino group, phenyl-$C_1$ to $C_{12}$ alkylamino group, a $C_1$ to $C_{12}$ alkoxyphenyl-$C_1$ to $C_{12}$ alkylamino group, a $C_1$ to $C_{12}$ alkylphenyl-$C_1$ to $C_{12}$ alkylamino group, a di($C_1$ to $C_{12}$ alkoxyphenyl-$C_1$ to $C_{12}$ alkyl) amino group, a di($C_1$ to $C_{12}$ alkylphenyl-$C_1$ to $C_{12}$ alkyl)amino group, a 1-naphthyl-$C_1$ to $C_{12}$ alkylamino group and a 2-naphthyl-$C_1$ to $C_{12}$ alkylamino group.

The substituted silyl group includes a silyl group which is substituted by one, two or three groups selected from an alkyl group, an aryl group, an arylalkyl group or a monovalent heterocyclic group. The substituted silyl group has a carbon number of generally from approximately 1 to 60 and preferably from 3 to 48. In addition, the alkyl group, aryl group, arylalkyl group or monovalent heterocyclic group may have a substituent.

The halogen atom includes a fluorine atom, a chlorine atom, a bromine atom and an iodine atom.

The acyl group has a carbon number of generally from approximately 2 to 20 and preferably from 2 to 18. The specific examples include an acetyl group, a propionyl group and a butyryl group.

The acyloxy group has a carbon number of generally from approximately 2 to 20 and preferably from 2 to 18. The specific examples include an acetoxy group, a propionyloxy group and a butyryloxy group.

The amide group has a carbon number of generally from approximately 2 to 20 and preferably from 2 to 18. The specific examples include a formamide group, an acetamide group, a propioamide group, a butyroamide group, a benzamide group and a trifluoroacetamide group.

The monovalent heterocyclic group means an atom group in which a hydrogen atom is removed from a heterocyclic compound, and has a carbon number of generally from approximately 4 to 60 and preferably from 4 to 20. In addition, the carbon number of a substituent is not included in the carbon number of the heterocyclic group. The heterocyclic compound referred to here is an organic compound having a ring structure in which the elements constituting a ring include not only a carbon atom but also heteroatoms such as oxygen, sulfur, nitrogen, phosphorus and boron in the ring. Specifically, there may be exemplified a thienyl group, a $C_1$ to $C_{12}$ alkylthienyl group, a pyrrolyl group, a furyl group, a pyridyl group, a $C_1$ to $C_{12}$ alkylpyridyl group, a piperidyl group, a quinolyl group and an isoquinolyl group, and preferred are a thienyl group, a $C_1$ to $C_{12}$ alkylthienyl group, a pyridyl group and a $C_1$ to $C_{12}$ alkylpyridyl group.

The substituted carboxyl group includes a carboxyl group which is substituted by an alkyl group, an aryl group, an arylalkyl group or a monovalent heterocyclic group and has a carbon number of generally from approximately 2 to 60 and preferably from 2 to 48. The specific examples include a methoxycarbonyl group, an ethoxycarbonyl group, a propoxycarbonyl group, an i-propoxycarbonyl group, a butoxycarbonyl group, an i-butoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group and a pyridyloxycarbonyl group. In addition, the alkyl group, aryl group, arylalkyl group or monovalent heterocyclic group may have a substituent. The carbon number of the substituent is not included in the carbon number of the substituted carboxyl group.

In the polymer, the both terminals of each charge-transport block are linked with other charge-transport blocks or forms terminals of the polymer. In this case, the segment linking between the charge-transport blocks may be directly linked or may be linked using a linking group as a spacer in some cases. Since the linking group may have an influence on the electronic properties, the segment is generally preferably linked directly. The linking group is not particularly limited, but a divalent group may be generally used by selecting stable divalent groups having an atom number of 100 or less and preferred is a stable divalent group having an atom number of 30 or less. Such a stable divalent group includes an alkenyl group and an alkoxyalkenyl group.

A variety of molecular structures can be used as a terminal group for the segment forming a terminal of polymer. For example, as such a terminal structure, there may be mentioned a group each independently selected from a hydrogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an amide group, an imide residue, a monovalent heterocyclic group, a carboxyl group, a substituted carboxyl group, a hydroxyl group, a sulfonate group, a cyano group, a hydroxy group, a phosphate group and a thiol group.

The polymer of the present invention may contain components other than the charge-transport blocks in the

polymer. Such components may be exemplified by various well-known components, and, for example, examples thereof include a light-emitting group, the linking group and the terminal group. The light-emitting group as referred to here includes a mono- or divalent group consisting of a well-known light-emitting compound (for example, a rubrene derivative, a perylene derivative, a quinacridone derivative, a coumarin derivative and a stilbene derivative).

If the amount of the components other than the charge-transport blocks becomes too large, since the components have an influence on the preferential adsorption of the charge-transport blocks, the amount of the components other than the charge-transport blocks is generally 30% by weight or less and preferably 10% by weight or less in the polymer.

One of the preferred polymers in the present invention is an asymmetric block copolymer containing two or more charge-transport blocks, and is an asymmetric block copolymer containing preferably 2 to 10, more preferably 2 to 4 charge-transport blocks. In addition, especially preferred is a polymer comprising a segment (A) in which the asymmetric block copolymer comprises one or two hole-transport blocks and a segment (B) comprising one or two electron-transport blocks directly or indirectly linked to the segment (A). In the present description, the asymmetric block copolymer means a structure in which the linking order of the terminal group, repeating unit and linking group from one end of the block copolymer is not same as that from another end of the block copolymer.

In the polymeric adsorption film of the present invention, it is preferable that at least one of the charge-transport blocks be a polyarylene residue or an aromatic polyamine residue, or at least one of the charge-transport blocks be a polyarylene residue and at least one of the charge-transport blocks be an aromatic polyamine residue. Further, it is more preferable that the polyarylene residue be a polyfluorene-diyl group which may have a substituent or a polybenzofluorene-diyl group which may have a substituent.

From the viewpoint of reproducibility and solubility in an organic solvent, the asymmetric block copolymer has a number average molecular weight in terms of polystyrene of preferably $1\times10^3$ or more, more preferably from $1\times10^3$ to $1\times10^8$ and especially preferably from $5\times10^3$ to $1\times10^7$. In addition, the asymmetric block copolymer has a weight average molecular weight in terms of polystyrene of preferably $4\times10^2$ or more, more preferably from $4\times10^2$ to $1\times10^7$ and especially preferably from $1\times10^3$ to $1\times10^6$.

The type of the charge-transport blocks constituting the asymmetric block copolymer is not particularly limited, and from the viewpoint of easiness of synthesis and easiness of the layer separation, the number of the type is preferably 2 to 10, more preferably 2 to 5, further more preferably 2 to 3 and especially preferably 2.

The asymmetric block copolymer is preferably the one in which at least one of the charge-transport blocks is a polyarylene residue, from the viewpoint of the high charge-transport property.

The polyarylene residue is a divalent group obtained by linking 5 or more divalent aromatic hydrocarbon groups. The divalent aromatic hydrocarbon group includes, for example, (E-1) to (E-28), a fluorene-diyl group which may have a substituent, a benzofluorene-diyl group which may have a substituent, a phenylene group which may have a substituent and a thienylene group which may have a substituent, and preferred are a fluorene-diyl group which may have a substituent and a benzofluorene-diyl group which may have a substituent. In addition, the fluorene-diyl group is a divalent group obtained by removing two hydrogen atoms bonded to the aromatic ring of fluorine. Further, the benzofluorene-diyl group is a divalent group obtained by removing two hydrogen atoms bonded to the aromatic ring of benzofluorene. In addition, the phenylene group is a divalent group obtained by removing two hydrogen atoms bonded to benzene. Further, the thienylene group is a divalent group obtained by removing two hydrogen atoms bonded to thiophene. The substituent includes those described in the substituent $R^c$.

From the viewpoint of easiness of synthesis and preferential adsorption, the asymmetric block copolymer is more preferably the one in which at least one of the charge-transport blocks is a polyarylene residue and at least one of the charge-transport blocks is an aromatic polyamine residue.

The aromatic polyamine residue is a divalent group obtained by bonding an aromatic hydrocarbon group to a nitrogen atom. As the specific examples of the aromatic polyamine, there may be mentioned a divalent group obtained by linking two or more of (D-10), (D-16) to (D-19), (D-22), (E-24), (G-1) to (G-8), (J-10), (J-20), (J-21) and the like, which are described above.

In the asymmetric block copolymer, it is preferable from the viewpoint of the function of an electronic device that at least one of the charge-transport blocks has an electron-transport property and at least one of the charge-transport blocks has a hole-transport property. Here, the electron-transport property is satisfied if the charge-transport blocks have any of a function of injecting an electron from a cathode, a function of transporting an electron and a function of blocking an hole injected from an anode. In addition, the hole-transport property is satisfied if the charge-transport blocks have any of a function of injecting a hole from an anode, a function of transporting a hole and a function of blocking an electron injected from a cathode. Such charge-transport blocks include a block comprising repeating units having a well-known electron-transport property or hole-transport property, or a block comprising repeating units derived from a compound having a well-known electron-transport properly or hole-transport property.

In the asymmetric block copolymer, at least one of the charge-transport blocks is required to have the property of preferentially adhering onto a substrate (an adhesive charge-transport block). For this reason, it is preferable that at

least one of the charge-transport blocks have a group suitable for adhesion, or be bonded to the terminal group suitable for adhesion (hereinafter, both may be collectively referred to as an "adhesion group"). Since such an adhesion group varies depending on the material of the uppermost surface of the substrate used, it may be arbitrarily selected from well-known adhesion groups. Such well-known adhesion groups include the following groups.

In the case where the uppermost surface layer of the substrate is made of metal or metal oxide, the adhesion group includes, for example, a hydroxy group, a phosphate group, a sulfonate group, a thiol group, a carboxyl group, an ester group, an amino group, a substituted amino group, an amide group, an alkylthio group, an aryloxy group, an arylthio group, an arylalkoxy group, an arylalkylthio group, a silyl group, a substituted silyl group, a halogen atom, an acyl group, an acyloxy group, a monovalent heterocyclic group and a cyano group. Specifically, these groups are the same as those described above.

For example, in the case where the substrate is made of gold or silver, a preferred adhesion group includes a group containing sulfur (such as a thiol group).

In addition, in the case where the uppermost surface layer of the substrate is made of a metal oxide such as an aluminum oxide, an indium tin oxide and glass, the adhesion group includes a hydroxyl group, a phosphate group, a sulfonate group, a thiol group, a carboxyl group, an ester group, an amino group, a substituted amino group, an amide group, an alkylthio group, an aryloxy group, an arylthio group, an arylalkoxy group, an arylalkylthio group, a silyl group, a substituted silyl group, a halogen atom, an acyl group, an acyloxy group, an imidyl group, a monovalent heterocyclic group and a cyano group, and preferred are a hydroxyl group, a phosphate group, a sulfonate group, a thiol group, a carboxyl group, an amino group, a substituted amino group and an amide group. specifically, these groups are the same as those described above.

For example, as the amino group and substituted amino group which are an adhesion group, there may be mentioned (D-1), (D-4) to (D-10), (D-16) to (D-22), (E-19) to (E-21), (E-24), (G-1) to (G-8), (J-7), (J-10), (J-20), (J-21), (K-1) to (K-4), (K-6) and the like, which are described above. From the viewpoint of being capable of stably dissolving the asymmetric block copolymer and preferential adsorption of the asymmetric block copolymer, the weight concentration of a nitrogen atom constituting these blocks is preferably 1% or more, more preferably 2% or more and further more preferably 3% or more.

In the asymmetric block copolymer, only one or two or more of the adhesive charge-transport blocks may be present. However, from the viewpoint of uniformity of the resulting thin polymeric adsorption film, reproducibility of production and easiness of synthesis, two or less of the adhesive charge-transport blocks are preferable and only one of that is more preferable.

A further more preferable asymmetric block copolymer contains, in addition to the adhesive charge-transport block, a charge-transport block (hereinafter, referred to as a "non-adhesive charge-transport block"), which has a relatively smaller adhesion force than the block. In order to preferentially adhere an adhesive charge-transport block to a surface of the substrate, the non-adhesive charge-transport block may have no adhesion groups or may have a smaller number of the adhesion groups than the adhesive charge-transport block, and preferably has no adhesion groups.

In the case where the uppermost surface layer of the substrate is hydrophobic (for example, when the surface is modified by an alkyl compound such as alkylsilanes and an alkyl carboxylic acid), the non-adhesive charge-transport block is generally preferentially adhered to the substrate, contrary to the case where the uppermost surface layer is made of metal or metal oxide.

In the polymeric adsorption film of the present invention, from the viewpoint of the uniformity of the thin film, the reproducibility of the polymeric adsorption film and easiness of synthesis, the asymmetric block copolymer comprises preferably two or less of the adhesive charge-transport blocks and three or less of the non-adhesive charge-transport blocks, more preferably two or less of the adhesive charge-transport blocks and two or less of the non-adhesive charge-transport blocks, further more preferably one adhesive charge-transport block and two or less of the non-adhesive charge-transport blocks, and especially preferably one adhesive charge-transport block and one non-adhesive charge-transport block.

Further, from the similar viewpoint, in the molecular chain terminals of the asymmetric block copolymer, it is more preferable that an adhesive charge-transport block be bonded to the terminal group at one molecular chain terminal and a non-adhesive charge-transport block be bonded to the terminal group at another molecular chain terminal, and it is especially preferable that the asymmetric block copolymer be comprising the two charge-transport blocks, an adhesive charge-transport block be bonded to the terminal group at one molecular chain terminal and a non-adhesive charge-transport block be bonded to the terminal group at another molecular chain terminal.

In one of the preferred embodiments of the present invention, the asymmetric block copolymer has a structure represented by the following formula (1):

$$\cdots\left(\cdots Ar^{11}\cdots\right)_{m^{11}}\cdots\left(\cdots Ar^{12}\cdots\right)_{m^{12}}\cdots\left(\cdots Ar^{13}\cdots\right)_{m^{13}}\cdots\ \cdots\ \cdots\left(\cdots Ar^{n}\cdots\right)_{m^{n}}\cdots \qquad (1)$$

wherein $Ar^{11}$, $Ar^{12}$, $Ar^{13}$,..., and $Ar^n$ (n is an integer of 12 or more) each independently represent a divalent conjugated group which may have a substituent in one charge-transport block, provided that the charge-transport blocks may be directly bonded together or may be bonded via a bonding group, and when the charge-transport blocks may be directly bonded together, the divalent conjugated group constituting two charge-transport blocks which are directly bonded are different each other; $m^{11}$, $m^{12}$, $m^{13}$,..., $m^n$ are each independently an integer of 5 or more.

In the above formula (1), the divalent conjugated group represented by $Ar^{11}$, $Ar^{12}$, $Ar^{13}$,..., and $Ar^n$ which may have a substituent is the same as the charge-transport group Ar.

In the above formula (1), among $m^{11}$, $m^{12}$, $m^{13}$,..., and $m^n$, at least two are an integer of preferably from 5 to $1\times10^6$, more preferably from $1\times10$ to $1\times10^4$, further more preferably from $1.5\times10$ to $1\times10^3$ and especially preferably from $2\times10$ to $5\times10^2$.

In a more preferred embodiment of the present invention, the asymmetric block copolymer is represented by the following formula (6):

$$R^X-\left(Ar^1\right)_{m^1}-\left(Ar^2\right)_{m^2}-\left(Ar^3\right)_{m^3}-R^Y \qquad (6)$$

wherein $Ar^1$, $Ar^2$ and $Ar^3$ each independently represent a divalent conjugated group which may have a substituent, provided that $Ar^1$ and $Ar^2$ are different and $Ar^2$ and $Ar^3$ are different; $R^X$ and $R^Y$ independently represent a terminal group; $m^1$, $m^2$ and $m^3$ are each independently an integer of 0 or more, provided that at least two of $m^1$, $m^2$ and $m^3$ are an integer of 5 or more; when $Ar^2$ has an adhesion group, $R^X$, $R^Y$, $Ar^1$ and $Ar^3$ have no adhesion groups; when $Ar^2$ has no adhesion groups, either one of $Ar^1$ and $R^X$ and either one of $Ar^3$ and $R^Y$ have an adhesion group.

In the above formula (6), a divalent conjugated group, which may have a substituent and is represented by $Ar^1$, $Ar^2$ and $Ar^3$, is the same as that described and exemplified as the divalent conjugated group, which may have a substituent and is represented by $Ar^{11}$, $Ar^{12}$, $Ar^{13}$,..., and $Ar^n$.

In the above formula (6), among $m^1$, $m^2$ and $m^3$, at least two are an integer of preferably from 5 to $1\times10^6$, more preferably from $1\times10$ to $1\times10^4$, further more preferably from $1.5\times10$ to $1\times10^3$ and especially preferably from $2\times10$ to $5\times10^2$.

In a further more preferred embodiment of the present invention, the asymmetric block copolymer is represented by the following formula (7):

$$R^P-\left(Ar^4\right)_{m^4}-\left(Ar^5\right)_{m^5}-R^Q \qquad (7)$$

wherein $Ar^4$ and $Ar^5$ each independently represent a divalent conjugated group which may have a substituent, provided that $Ar^4$ and $Ar^5$ are different; $R^P$ and $R^Q$ each independently represent a terminal group; $m^4$ and $m^5$ each independently are an integer of 5 or more; $Ar^4$, $R^P$, $Ar^5$ or $R^Q$ has an adhesion group.

In the above formula (7), a divalent conjugated group, which may have a substituent and is represented by $Ar^4$ and $Ar^5$, is the same as that described and exemplified as the divalent conjugated group, which may have a substituent and is represented by $Ar^{11}$, $Ar^{12}$, $Ar^{13}$,..., and $Ar^n$.

In the above formula (7), $m^4$ and $m^5$ are an integer of preferably from 5 to $1\times10^5$, more preferably from $1\times10$ to $1\times10^4$, further more preferably from $1.5\times10$ to $1\times10^3$ and especially preferably from $2.0\times10$ to $5\times10^2$.

As the examples of the asymmetric block copolymers represented by the above formula (7), preferred are the following block copolymers. In the formulas, m and n each independently are the same as the above $m^4$ and $m^5$. In the Table, $R^D$ each independently represent a hydrogen atom, or an alkyl group, an aryl group or an arylalkyl group. An alkyl group, an aryl group and an arylalkyl group are the same as those explained and described as the alkyl group, the aryl group and the arylalkyl group. $R^F$ and $R^G$ each independently represent a terminal group.

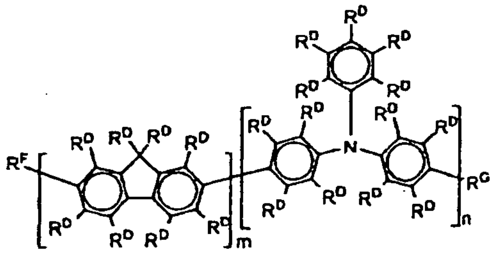

(L-1)

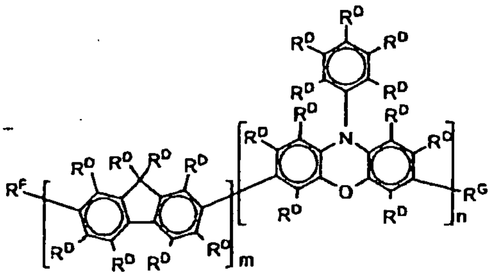

(L-2)

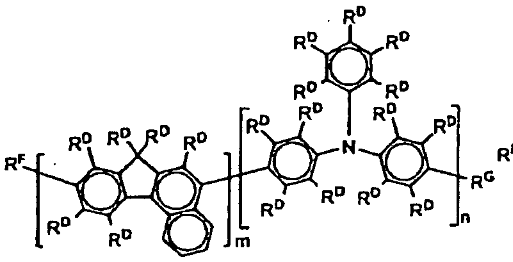

(L-3)

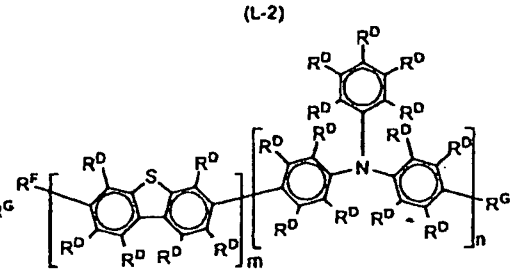

(L-4)

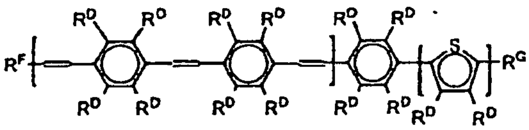

(L-5)

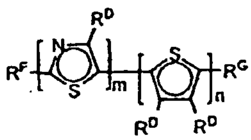

(L-6)

As the examples of the asymmetric block copolymers represented by the above formula (7), preferred are the following block copolymers. In the formulas, m and n each independently are the same as the above $m^4$ and $m^5$.

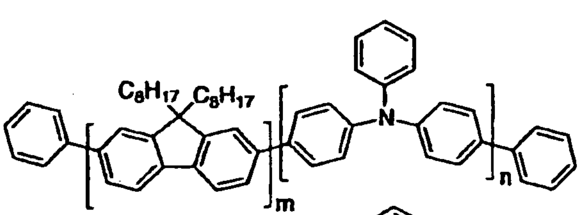

(K-1)

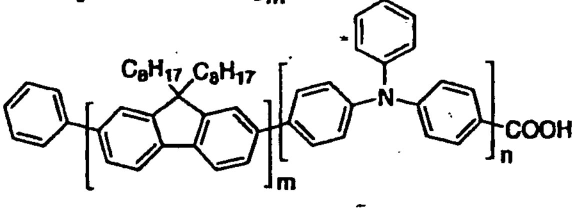

(K-2)

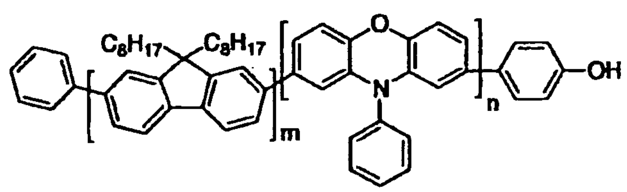

(K-3)

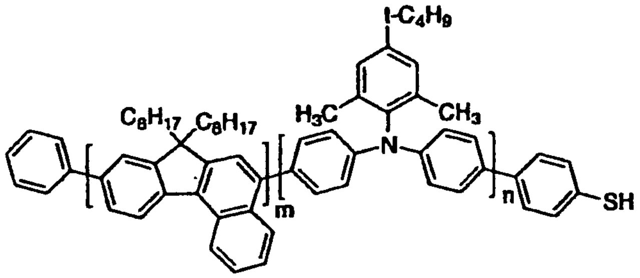

(K-4)

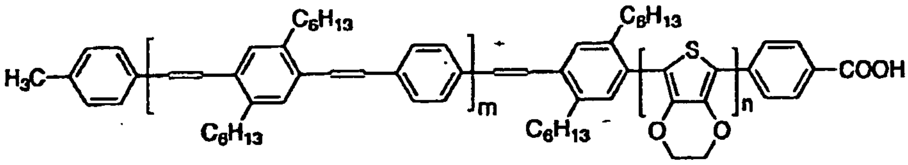

(K-5)

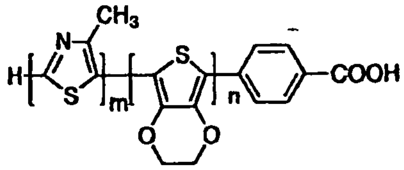

(K-6)

The asymmetric block copolymers have a number average molecular weight Mn in terms of polystyrene of generally from $1\times10^3$ to $1\times10^8$, preferably from $5\times10^3$ to $1\times10^7$, more preferably from $1\times10^4$ to $1\times10^6$ and further more preferably from $2\times10^4$ to $5\times10^5$. In addition, the asymmetric block copolymers have a weight average molecular weight Mw in terms of polystyrene of generally from $1\times10^3$ to $1\times10^8$, and from the viewpoint of the film formability of the thin film, preferably from $5\times10^3$ to $1\times10^7$, more preferably from $1\times10^4$ to $5\times10^6$ and further more preferably from $5\times10^4$ to $5\times10^6$, and from $5\times10^4$ to $5\times10^5$. The number average molecular weight and the weight average molecular weight of the asymmetric block copolymers can be measured by size exclusion chromatography (hereinafter, referred to as "SEC").

The asymmetric block copolymer may be the one which is produced by any production process and can be produced by a well-known process, for example, by condensation polymerization of two or more compounds represented by the following general formula (b).

**$M^1$-Ar-$X^1$** (b)

wherein Ar is the same as Ar in the above formula (1); $X^1$ represents a halogen atom, a sulfonate group represented by the following formula (c) or a methoxy group; $M^1$ represents a boric acid ester residue, a boric acid residue, a group represented by the following formula (d), a group represented by the following formula (e), or a group represented by the following formula (f);

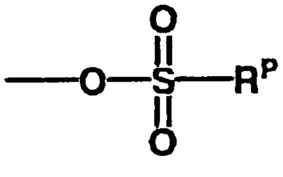

(c)

wherein $R^P$ represents an alkyl group which may have a substituent or an aryl group which may have a substituent;

**-MgXA** (d)

wherein $X_A$ represents a chlorine atom, a bromine atom or an iodine atom;

**-ZnXA** (e)

wherein $X_A$ represents a chlorine atom, a bromine atom or an iodine atom;

**-SnRQRRRS** (f)

wherein $R^Q$, $R^R$ and $R^S$ each independently represent an alkyl group which may have a substituent or an aryl group which may have a substituent.

In the above formula (b), the halogen atom represented by $X^1$ includes a chlorine atom, a bromine atom or an iodine atom.

In the above formula (c), an alkyl group and an aryl group constituting an alkyl group which may have a substituent and aryl group which may have a substituent both represented by $R^P$, are the same as those explained and described as the alkyl group and the aryl group. These atoms and groups are the same as described above.

Examples of the sulfonate group represented by the above formula (c) include a methanesulfonate group, a trifluoromethanesulfonate group, a phenylsulfonate group and a 4-methylphenylsulfonate group.

In the above formula (b), examples of the boric acid ester residue represented by $M^1$ include a group represented by the following formula.

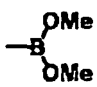 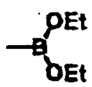 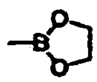 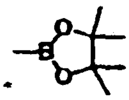 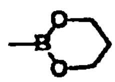 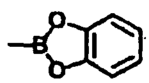

<Production Process>

Next, there will be described a process for producing a polymeric adsorption film of the present invention. The polymeric adsorption film of the present invention may be prepared by adhering the polymer to a suitable substrate under a suitable environment. The adhesion method includes a method of adsorbing the polymer to a suitable substrate or a method of applying the polymer to a suitable substrate. Preferred is a method including a step in which a solution of the polymer is immersed in the substrates or is applied to the substrate and then the polymer is brought into contact with a good solvent of the polymer.

The adsorption or application step may be carried out in a gas, liquid or solid phase depending on the type and molecular weight of the asymmetric block copolymer, and from the viewpoint of the easiness of handling, the step is preferably carried out in a liquid phase. When the step is carried out in a gas phase, the polymer is deposited on a clean substrate in a vacuum by a method such as vapor deposition, thereby enabling to form a polymeric adsorption film. When the step is carried out in a solid phase, there may be used a method of rubbing the asymmetric block copolymer on a clean substrate. When the step is carried out in a liquid phase, the step includes a method of immersing a substrate in a solution of the asymmetric block copolymer and a method of applying a solution of the asymmetric block copolymer to a substrate.

Even when any of the methods is used, the substrate is required to be cleaned. At this time, if a surface of the substrate is contaminated with dust and the like, defects occur to a thin film containing an asymmetric block copolymer. For this reason, it is desirable that the bonding step such as adsorption be started immediately after the cleaning of the substrate. The cleaning method varies depending on the type of the.substrate, and a well-known method may be used for each substrate. In order to form a thin film containing the asymmetric block copolymer with less defects, at the final step of cleaning, the film is treated preferably with ozone, plasma and the like, more preferably with active oxygen species such as ozone and oxygen plasma, and especially preferably with ozone from the viewpoint of convenience.

There will be described the method of immersing the substrate in a solution of the asymmetric block copolymer. The concentration of a solution of the asymmetric block copolymer varies depending on the type of the asymmetric block copolymers, and can be adjusted in a range where the asymmetric block-copolymer can be stably dissolved. From the viewpoint of stably obtaining the thin film, the concentration of a solution of the asymmetric block copolymer is preferably 0.001 to 1000 g/L and in a range where the asymmetric block copolymer can be stably dissolved, more preferably 0.01 to 100 g/L and in a range where the asymmetric block copolymer can be stably dissolved, and especially preferably 0.01 to 10 g/L and in a range where the asymmetric block copolymer can be stably dissolved. The time of immersing the substrate in a solution of the asymmetric block copolymer varies depending on the type of the asymmetric block copolymers, and generally is within 30 hours.

In addition, the solution of a polymer used is preferably used after removing impurities as much as possible. Especially, if dust and other molecules adsorbable to a surface of the substrate are mixed in, defects of the resulting polymeric adsorption film occur.

Further, it is preferable that excessive polymer be removed from a polymer and a substrate after immersing, where necessary, depending on the formation method of the polymeric adsorption film. The removal method includes a method of washing with a solvent used. As the solvent, it is desirable to select one which will dissolve the polymer and will not remove a polymeric adsorption film from the substrate. In general, in case of the immersion step, the solvent used in the step is generally preferable. In the case of forming a polymeric adsorption film of the present invention by application, the above removal is favorable, because in general, such an excessive polymer is likely to be generated in a large amount.

<Electronic Device>

An electronic device of the present invention contains the polymeric adsorption film and more specifically can be used by replacing a part of a multilayer structure of a well-known electronic device having a multilayer structure of organic materials by a thin film obtained by removing a substrate from a polymeric adsorption film of the present invention. That is, the electronic device may have, in addition to the polymeric adsorption film or the thin film obtained by removing a substrate from a polymeric adsorption film, a layer such as an anode, a cathode, a hole-transport layer, an electron-transport layer, a hole injection layer, an electron injection layer, a hole prevention layer, an electron prevention layer, a light-emitting layer and a buffer layer. The structure of the electronic device of the present invention is not particularly limited, and one preferred embodiment of the electronic device of the present invention has, for example, a structure in which a polymeric adsorption film of the asymmetric block copolymer is formed on a layer comprising an indium tin oxide, and an electron-transport layer and a cathode metal are further laminated in order on the polymeric adsorption film. Here, in the case where a material constituting the asymmetric block copolymer or the electron-transport layer contains a partial structure having a light-emitting function, the electronic device can be used as light emitting device. The electronic device of the present invention can be used for a light emitting device and a photoelectric conversion device. Even for these devices, there may be used a constitution in which a part of a multilayer structure of a well-known light emitting device having a multilayer structure of organic materials or a photoelectric conversion device is replaced by a polymeric adsorption film of the present invention.

Hereinafter, the present invention will be described by examples in more detail, but the present invention will not be limited by these examples.

The number average molecular weight (Mn) and the weight average molecular weight (Mw) in terms of polystyrene were determined by size exclusion chromatography (SEC) under the following conditions.

Apparatus: HLC-8220 GPC, manufactured by Tosoh Corporation
Column: The following four columns were connected in series.

One piece of TSK guard column Super H-H (manufactured by Tosoh Corporation)
Two pieces of TSK gel Super HM-H (manufactured by Tosoh Corporation)
One piece- of TSK gel Super H2000 (manufactured by Tosoh Corporation)

Mobile phase: Tetrahydrofuran
Detector: Differential refractive index detector

The weight concentration of nitrogen contained in an asymmetric block copolymer was determined by elemental analysis (automated CHN analysis).

Apparatus: vario EL, manufactured by Elementar Analysis System.

<Synthesis Example 1> -Synthesis of Asymmetric Block Copolymer A-

A 300 ml three-necked flask was charged with 1.00 g (1.5 mmol) of a compound B represented by the following formula:

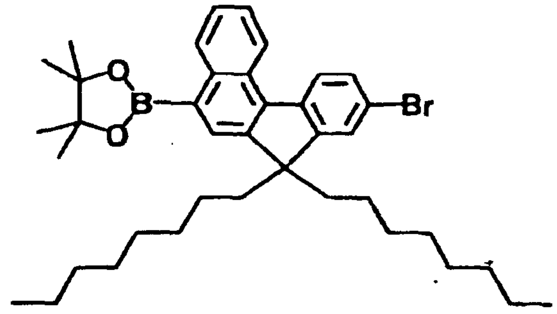

and the air in the flask was replaced by argon. Into the flask were charged 6.6 mg (0.03 mmol) of 4-t-butylbromobenzene and 34 ml of toluene, followed by stirring at 45°C for 5 minutes. Thereafter, to the resulting mixture were added 2.1 mg (0.002 mmol) of tris(dibenzylideneacetone)dipalladium and 6.5 mg (0.018 mmol) of tris(2-methoxyphenyl)phosphine and stirred at 45°C for 10 minutes, and then 7.0 ml of 30% by weight of an aqueous solution of cesium carbonate was added and stirred at 45°C for 5 minutes. Subsequently, the resulting mixture was stirred at 110°C for 2.5 hours to confirm the disappearance of the compound B by high performance liquid chromatography. Here, it was confirmed that the number average molecular weight in terms of polystyrene of the peak top in SEC was $5.2\times10^4$.

Then, into the flask were added 2.23 g (4.2 mmol) of a compound C represented by the following formula:

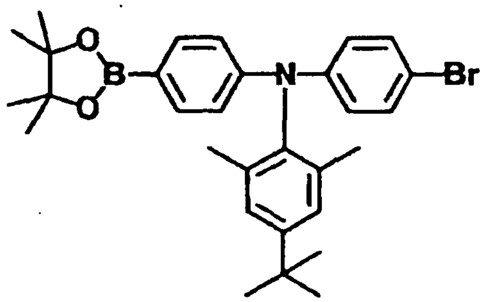

, 5.7 mg (0.006 mmol) of tris(dibenzylideneacetone)dipalladium, 17.4 mg (0.049 mmol) of tris(2-methoxyphenyl)phosphine, 19 mL of 30% by weight of an aqueous solution of cesium carbonate and 9 mL of toluene, followed by stirring at 110°C for 17 hours. Thereafter, the disappearance of the compound C was confirmed by high performance liquid chromatography. Here, it was confirmed that the number average molecular weight in terms of polystyrene of the peak top in SEC was $8.1\times10^4$ and the molecular weight was increased by copolymerization.

Subsequently, to the mixture were added 0.46 g (2.1 mmol) of 4-(4,4,5,5-tetramethyl-1,3,2-dioxaborane-2-yl) toluene and 2 mL of toluene, followed by stirring at 110°C for 3 hours. After cooling to room temperature, the reaction solution was separated into an organic layer and an aqueous layer. The organic layer was dropwise added to 375 mL of ethanol to obtain a precipitate and the precipitate was filtered and dried to obtain a yellow solid. The yellow solid was dissolved in 125 mL of toluene and the resulting solution was concentrated and dried by subjecting to silica gel and activated alumina column chromatography. The resulting solid was dissolved in tetrahydrofuran and the resulting solution was dropwise added to acetone to obtain a precipitate. The precipitate was filtered and dried three times to obtain a solid. The solid was dissolved in toluene and the resulting solution was dropwise added to methanol to obtain a precipitate. The precipitate was filtered and dried to obtain 1.1 g of an asymmetric block copolymer A.

The elemental analysis result showed that the asymmetric block copolymer A had a molar ratio of the repeating unit A represented by the following formula:

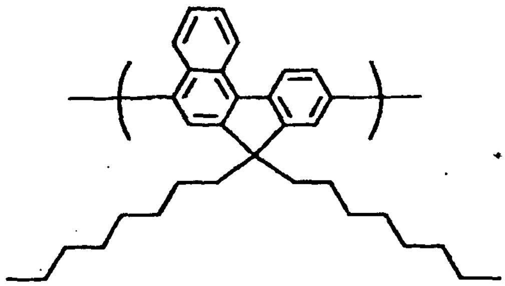

and the repeating unit B represented by the following formula:

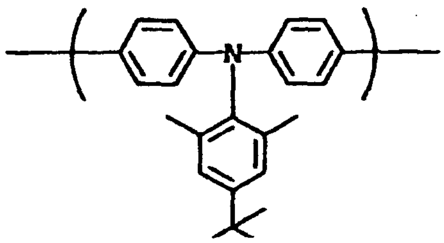

of 32:68. In addition, the asymmetric block copolymer A had a number average molecular weight Mn in terms of polystyrene of $5.1\times10^4$ and a weight average molecular weight Mw in terms of polystyrene of $8.1\times10^4$.

<Synthesis Example 2> - Synthesis of Polymer D -

A 100 ml two-necked flask was charged with 1.00 g (1.5 mmol) of the compound B and the air in the flask was replaced by argon. Into the flask was charged 34 mL of toluene, followed by stirring at 45°C for 5 minutes. Thereafter, to the resulting mixture were added 2.1 mg (0.002 mmol) of tris(dibenzylideneacetone)dipalladium and 6.6 mg (0.019 mmol) of tris(2-methoxyphenyl)phosphine and stirred at 45°C for 10 minutes, and then 7.0 ml of 30% by weight of an aqueous solution of cesium carbonate was added and at 45°C for 5 minutes, and thereafter stirred at 110°C for 4 hours. Subsequently, to the mixture were added 50.4 mg of 2-[4-(1,1-dimethylethyl)phenyl]-4,4,5,5,-tetramethyl-1,3,2-dioxaborane and 2.5 mL of toluene, followed by stirring at 110°C for 2 hours. Then, to the resulting mixture was added 70.0 mg of 4-t-butylbromobenzene, followed by stirring at 110°C for 16 hours. After cooling to room temperature, the reaction solution was dropwise added to 380 mL of ethanol to obtain a precipitate and the precipitate was filtered and dried to obtain a solid. The solid was dissolved in 48 mL of toluene and the resulting solution was concentrated and dried by subjecting to silica gel and activated alumina column chromatography. The solid was dissolved in 43 mL of chloroform and the resulting solution was dropwise added to 260 mL of ethanol to obtain a precipitate. The precipitate was filtered and dried to obtain 0.64 g of a polymer D which is only composed of the repeating unit A. The polymer D had a number average molecular weight Mn in terms of polystyrene of $6.3\times10^4$ and a weight average molecular weight Mw in terms of polystyrene of $1.2\times10^5$.

<Synthesis Example 3> - Synthesis of Polymer E -

A 1 liter two-necked flask was charged with 4.87 g (0.01 mol) of a compound F represented by the following formula:

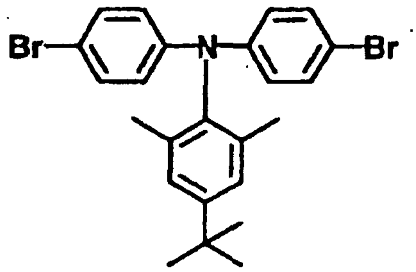

and the air in the flask was replaced by argon. Into the flask were charged 4.22 g (0.027 mol) of 2,2-piperidyl, 720 mL of tetrahydrofuran and 7.43 g (0.027 mol) of bis-(1,5-cyclooctadiene), followed by stirring at 60°C for 3 hours. After cooling to room temperature, the reaction solution was dropwise added to a mixture solution of 720 mL of methanol, 720 mL of ion exchange water and 36 mL of 25% aqueous ammonia to obtain a precipitate. The precipitate was filtered and vacuum dried. Thereafter, the resulting precipitate was dissolved in 300 mL of toluene and Radiolite was added and stirred to filter insoluble materials. After the resulting filtrate was purified by passing through an alumina column, 590 mL of 5.2% hydrochloric acid was added and stirred to remove an aqueous layer. Then, to an organic layer was added 590 mL of 4% aqueous ammonia and stirred, and then the aqueous layer was removed, and further to the organic layer was added 590 mL of ion exchange water and stirred, followed by removing the aqueous layer. Subsequently, the organic layer was dropwise added to 940 mL of methanol to obtain a precipitate while stirring for 30 minutes, and then the precipitate was filtered and vacuum dried to obtain a polymer F which is only composed of the repeating unit B. The polymer D had a number average molecular weight in terms of polystyrene of $5.8\times10^3$ and a weight average molecular weight in terms of polystyrene of $1.2\times10^4$.

<Synthesis Example 4> -Synthesis of Asymmetric Block Copolymer G-

A 200 ml three-necked flask was charged with 1.00 g (1.5 mmol) of the compound B and the air in the flask was replaced by argon. Into the flask were charged 6.6 mg (0.03 mmol) of 4-t-butylbromobenzene and 34 ml of toluene, followed by stirring at 45°C for 5 minutes. Thereafter, to the resulting mixture were added 2.2 mg (0.002 mmol) of tris (dibenzylideneacetone)dipalladium and 6.6 mg (0.019 mmol) of tris(2-methoxyphenyl)phosphine and stirred at 45°C for 10 minutes, and then 7.0 ml of 33% by weight of an aqueous solution of cesium carbonate was added and stirred at 45°C for 7 minutes. Thereafter, the resulting mixture was stirred at 110°C for 3 hours to confirm the disappearance of the compound B by high performance liquid chromatography. Here, it was confirmed that the number average molecular weight in terms of polystyrene of the peak top in SEC was $7.1\times10^4$.

Subsequently, into the flask were added 0.82 g (1.5 mmol) of the compound C and 10 mL of toluene, followed by stirring at 110°C for 21 hours. Thereafter, the disappearance of the compound C was confirmed by high performance liquid chromatography. Here, it was confirmed that the number average molecular weight in terms of polystyrene of the peak top in SEC was $8.9\times10^4$ and the molecular weight was increased by copolymerization.

Then, to the mixture were added 0.17 g (0.78 mmol) of 4-(4,4,5,5-tetramethyl-1,3,2-dioxaborane-2-yl) toluene and 2 mL of toluene, followed by stirring at 110°C for 3 hours. After cooling to room temperature, the reaction solution was dropwise added to 500 mL of ethanol to obtain a precipitate. The precipitate was filtered and dried to obtain a yellow solid. The yellow solid was dissolved in 65 mL of toluene and the resulting solution was concentrated and dried by subjecting to silica gel and activated alumina column chromatography. A solution obtained by dissolving the resulting solid in chloroform was dropwise added to ethanol, and the resulting precipitate was filtered and dried to obtain 0.82 g of a solid. In tetrahydrofuran was dissolved 0.73 g of the solid and the resulting solution was dropwise added to acetone to obtain a precipitate. The precipitate was filtered and dried four times to obtain 0.40 g of an asymmetric block copolymer G

The elemental analysis result showed that the asymmetric block copolymer G had a molar ratio of the repeating unit A represented by the above formula and the repeating unit B represented by the above formula of 66:34. In addition, the asymmetric block copolymer A had a number average molecular weight Mn in terms of polystyrene of $7.2\times10^4$ and a weight average molecular weight Mw in terms of polystyrene of $1.1\times10^5$.

<Synthesis Example 5> -Synthesis of Asymmetric Block Copolymer H-

A 300 ml three-necked flask was charged with 1.00 g (1.5 mmol) of the compound B and the air in the flask was replaced by argon. Into the flask were charged 6.6 mg (0.03 mmol) of 4-t-butylbromobenzene and 34 ml of toluene, followed by stirring at 45°C for 5 minutes. Thereafter, to the resulting mixture were added 2.1 mg (0.002 mmol) of tris (dibenzylideneacetone)dipalladium and 6.6 mg (0.018 mmol) of tris(2-methoxyphenyl)phosphine and stirred at 45°C for

10 minutes, and then 7.0 ml of 30% by weight of an aqueous solution of cesium carbonate was added and stirred at 45°C for 5 minutes. Subsequently, the resulting mixture was stirred at 110°C for 4 hours to confirm the disappearance of the compound B by high performance liquid chromatography. Here, it was confirmed that the number average molecular weight in terms of polystyrene of the peak top in SEC was $5.6\times10^4$.

Then, into the flask were added 5.12 g (9.6 mmol) of the compound C, 13.2 mg (0.014 mmol) of tris(dibenzylideneacetone)dipalladium, 40.6 mg (0.115 mmol) of tris(2-methoxyphenyl)phosphine, 44 mL of 33% by weight of an aqueous solution of cesium carbonate and 10 mL of toluene, followed by stirring at 110°C for 14.5 hours. Thereafter, the disappearance of the compound C was confirmed by high performance liquid chromatography. Here, it was confirmed that the number average molecular weight in terms of polystyrene of the peak top in SEC was $1.0\times10^5$ and the molecular weight was increased by copolymerization.

Subsequently, to the mixture were added 1.05 g (4.8 mmol) of 4-(4,4,5,5-tetramethyl-1,3,2-dioxaborane-2-yl) toluene and 2 mL of toluene, followed by stirring at 110°C for 3 hours. By carrying out the same purification operation as in Synthesis Example 5, 2.5 g of an objective asymmetric block copolymer H was obtained.

The elemental analysis result showed that the asymmetric block copolymer H had a molar ratio of the repeating unit A represented by the above formula and the repeating unit B represented by the above formula of 17:83. In addition, the asymmetric block copolymer A had a number average molecular weight Mn in terms of polystyrene of $7.2\times10^4$ and a weight average molecular weight Mw in terms of polystyrene of $1.2\times10^5$.

<Example 1> -Preparation of Polymeric Adsorption Film -

The adhered materials on a glass substrate surface were removed by washing with an organic solvent (toluene and tetrahydrofuran), an aqueous solution of an alkaline detergent and distilled water and then exposing to ozone gas for 3 minutes. The glass substrate was immersed in a THF solution ($5\times10^{-2}$ g/L) of the asymmetric block copolymer A and pulled out after allowing to stand for 3 days, followed by drying by spraying toluene. When ultraviolet light was irradiated on the resulting glass substrate, fluorescence was visually confirmed. In addition, the fluorescence spectrum was measured by setting the excitation wavelength at 350 nm. The fluorescence spectra thus obtained are shown in Figure 1. From the features of the fluorescence spectra, the fluorescence emission by the asymmetric block copolymer A was confirmed. That is, it was ascertained that the asymmetric block copolymer A is adhered to the glass substrate.

<Comparative Example 1> -Preparation of Polymeric Film for Comparison -

An experiment was carried out in the same manner as in Example 1 except that the glass substrate instead of the polymer A was immersed in a THF solution ($5\times10^{-2}$ g/L) of the polymer D. When ultraviolet light was irradiated on the resulting glass substrate, no fluorescence was visually confirmed. Further, the fluorescence spectrum was measured by setting the excitation wavelength at 350 nm. The fluorescence spectra thus obtained are shown in Figure 1. In addition, since the faint fluorescence spectra observed are also not due to the fluorescence emission by the polymer D, the polymer D is not adhered to the glass substrate.

<Evaluation>

When Example 1 and Comparative Example 1 are compared, it is clearly understood that the block composed of the repeating unit B having an amino group is preferentially adhered to the substrate in the polymeric adsorption film in Example 1. The block composed of the repeating unit A composed of benzofluorene used in Comparative Example 1 is hardly adsorbed to the glass substrate. Therefore, in Example 1, the block composed of the repeating unit A is hardly adsorbed to the glass substrate but is adsorbed to a substrate by the block composed of the repeating unit B.

<Example 2> -Preparation of Polymeric Adsorption Film -

The adhered materials on a glass substrate surface were removed by washing with chloroform, methanol, an aqueous solution of an alkaline detergent, distilled water and acetone and then exposing to ozone gas for one minute. The glass substrate was immersed in a THF solution (5 g/L) of the asymmetric block copolymer A and pulled out after allowing to stand for 3 days, followed by washing by spraying toluene and vacuum drying. By adhering 0.5 μL of ultrapure water to the resulting polymeric adsorption film, the contact angle was measured to be 60.1°. The results obtained are shown in Table 1.

<Comparative Example 2> - Preparation of Polymer Spin-Coated Film for Comparison -

A spin-coated film was prepared on a glass substrate using a THF solution (2.5 g/L) of the polymer D, and the

contact angle of the resulting polymer film (not an adsorption film) was measured to be 67.4°. The results obtained are shown in Table 1.

<Comparative Example 3> -Preparation of Polymer Film for Comparison-

An experiment was carried out in the same manner as in Example 1 except for immersing the glass substrate in a THF solution ($5\times10^{-2}$ g/L) of the polymer E. The resulting polymer film had a contact angle of 34.5°, showing a high value in hydrophilicity. The results obtained are shown in Table 1.

Table 1

| | Polymer | Constitutional unit | Film preparation method | Contact angle | Hydrophilicity / Water repellency |
|---|---|---|---|---|---|
| Example 2 | Asymmetric block copolymer A | A and B | Adsorption | 60.1 | Water repellency |
| Comparative Example 2 | Polymer D | A | Spin-coated | 67.4 | Water repellency |
| Comparative Example 3 | Polymer E | B | Adsorption | 34.5 | Hydrophilicity |

<Evaluation>

When the contact angle of Example 2 and that of Example 3 are compared, the uppermost surface of the polymer D film composed only of the constitutional unit A is higher in water repellency and the uppermost surface of the polymer E film composed only of the constitutional unit B is higher in hydrophilicity. On the other hand, the polymeric adsorption film of the asymmetric diblock copolymer A (Example 2) is high in water repellency, showing a contact angle near to the value of Comparative Example 2. This fact shows that, in the polymeric adsorption film prepared in Example 2, many constitutional units A exist on the uppermost surface and adsorptive constitutional units B exist near the substrate.

<Example 3> -Preparation of Polymeric Adsorption Film-

An experiment was carried out in the same manner as in Example 2 except for changing the THF solution concentration of the asymmetric block copolymer A to $5\times10^{-2}$ g/L and immersing the glass substrate in the THF solution. In addition, the fluorescence spectrum was measured by setting the excitation wavelength at 350 nm. The fluorescence spectrum thus obtained is shown in Figure 2.

<Example 4> -Preparation of Polymeric Adsorption Film-

An experiment was carried out in the same manner as in Example 2 except for immersing the glass substrate in a THF solution ($5\times10^{-2}$ g/L) of the asymmetric block polymer G. In addition, the fluorescence spectrum was measured by setting the excitation wavelength at 350 nm. The fluorescence spectrum thus obtained is shown in Figure 2.

<Example 5> -Preparation of Polymeric Adsorption Film-

An experiment was carried out in the same manner as in Example 2 except for immersing the glass substrate in a THF solution ($5\times10^{-2}$ g/L) of the asymmetric block polymer H. In addition, the fluorescence spectrum was measured by setting the excitation wavelength at 350 nm. The fluorescence spectrum thus obtained is shown in Figure 2.

<Evaluation>

In Figure 2, the graphs of Examples 3 to 5 show that the asymmetric block copolymer having a high content of the component N is more frequently adsorbed to the glass substrate. Therefore, the block composed of the repeating unit B containing the component N is preferentially adsorbed to the substrate.

<Example 6> -Preparation of Polymeric Adsorption Film-

The adhered materials on the ITO substrate were removed by washing with chloroform, methanol, an aqueous solution of an alkaline detergent, distilled water and acetone and then exposing to ozone gas for one minute. The ITO substrate was immersed in a THF solution (5 g/L) of the asymmetric block copolymer H and pulled out after allowing to stand for 3 days, followed by washing by spraying THF and vacuum drying. The polymer D was spin coated on the polymer adsorption film so that the film thickness is approximately 135 nm, and then 50 nm of gold was vapor-deposited on the film and current-voltage measurement was performed. The current-voltage measurement of the polymeric adsorption film prepared in Example 6 was carried out and the results showed that a current of $3.04 \times 10^{-6}$ A flowed when a voltage of 12 V was applied. The results obtained are shown in Table 2.

<Comparative Example 4> - Preparation of Polymeric Film for Comparison (Not an Adsorption Film) -

The adhered materials on the ITO substrate surface were removed by washing with chloroform, methanol, an aqueous solution of an alkaline detergent, distilled water and acetone. The polymer D was spin coated on the ITO substrate so that the film thickness is approximately 135 nm, and then 50 nm of gold was vapor-deposited on the film and current-voltage measurement was performed. The results obtained are shown in Table 2.

<Comparative Example 5> - Preparation of Polymeric Film for Comparison (Not an Adsorption Film) -

The adhered materials on the ITO substrate surface were removed by washing with chloroform, methanol, an aqueous solution of an alkaline detergent, distilled water and acetone. The polymer E was spin coated on the ITO substrate so that the film thickness is approximately 10 nm and then dried. Thereafter, the polymer D was spin coated so that the film thickness is approximately 135 nm, and then 61 nm of gold was vapor-deposited and current-voltage measurement was performed. The results obtained are shown in Table 2.

<Comparative Example 6> - Preparation of Polymeric Film for Comparison (Not an Adsorption Film) -

The adhered materials on the ITO substrate surface were removed by washing with chloroform, methanol, an aqueous solution of an alkaline detergent, distilled water and acetone. The polymer E was spin coated on the ITO substrate so that the film thickness is approximately 10 nm and then dried. Thereafter, the polymer D was spin coated so that the film thickness is approximately 135 nm, and then 61 nm of gold was vapor-deposited and current-voltage measurement was performed. The results obtained are shown in Table 2.

Table 2

| | Polymeric adsorption film | Spin-coated film | Current $\times 10^{-6}$ (A) | |
|---|---|---|---|---|
| | | | 10 V | 12V |
| Example 6 | Asymmetric block copolymer H | Polymer D | 1.62 | 3.04 |
| Comparative Example 4 | None | Polymer D | 0.97 | 1.43 |
| Comparative Example 5 | None | Polymers D and E | 0.89 | 1.77 |
| Comparative Example 6 | None | Polymers D and E | 0.80 | 2.37 |

<Evaluation>

When the results of Example 6 and Comparative Example 4 are compared, it is understood that no current flows in Comparative Example 4 as compared with Example 6. This fact shows that the constitutional unit B of the asymmetric diblock copolymer H is adsorbed to the substrate to flow a current. When the results of Example 6 and Comparative Examples 5 and 6 are compared, it is understood that the polymeric adsorption film can inject charges to the polymer D equally or more to a polymeric film on which the polymer E is spin-coated.

**Industrial Applicability**

A polymeric adsorption film of the present invention may be produced more conveniently and through a smaller number of steps than a multilayer structure (for example, a two-layer structure) produced by usual lamination techniques,

while having functions of a multilayer structure (for example, a two-layer structure). Accordingly, the polymeric adsorption film of the present invention is useful as a member of an electronic device such as a light emitting device, and a device using these members may be produced more conveniently and through a smaller number of steps than a general multilayer structure.

## Claims

1. A polymeric adsorption film comprising a polymer containing two or more charge-transport blocks and a substrate having the polymer thereon, wherein any of the charge-transport blocks is preferentially adhered to a surface of the substrate.

2. A polymeric adsorption film comprising a polymer containing two or more charge-transport blocks and a substrate having the polymer thereon, wherein any of charge-transport blocks different from the charge-transport blocks preferentially adhered to a surface of the substrate is preferentially exposed.

3. A polymeric adsorption film comprising a polymer and a substrate, wherein the polymer contains two or more charge-transport blocks and any charge-transport block selected from the charge-transport blocks is adhered to a surface of the substrate more preferentially than the other charge-transport blocks.

4. The polymeric adsorption film according to any of Claims 1 to 3, wherein the polymer satisfies the following equation:

$$Z_A > Z > (Z_A + Z_B) / 2$$

wherein Z is a contact angle value of a film of the polymer shown above, $Z_A$ is the largest value of the contact angle of a film of a polymer comprising one charge-transport block possessed by the polymer referred in the definition of Z, and $Z_B$ is a smallest value of the contact angle.

5. The polymeric adsorption film according to any of Claims 1 to 3, wherein the polymer comprises two or more charge-transport blocks and satisfies the following equation:

$$Z_B < Z < (Z_A + Z_B) / 2$$

wherein Z is a contact angle value of a film of the polymer shown above, $Z_A$ is the largest value of the contact angle of a film of a polymer comprising one charge-transport block possessed by the polymer referred in the definition of Z, and $Z_B$ is the smallest value of the contact angle.

6. The polymeric adsorption film according to any of Claims 1 to 3, wherein the polymer has a number average molecular weight in terms of polystyrene of $10^3$ or more and $10^8$ or less.

7. The polymeric adsorption film according to any of Claims 1 to 3, wherein at least one of the charge-transport blocks possessed by the polymer has a light-emitting property.

8. The polymeric adsorption film according to any of Claims 1 to 3, wherein at least one of the charge-transport blocks possessed by the polymer has an electron-transport property and at least one of the charge-transport blocks has a hole-transport property.

9. The polymeric adsorption film according to any of Claims 1 to 3, wherein the polymer is an asymmetric block copolymer.

10. The polymeric adsorption film according to any of Claims 1 to 3, wherein at least one of the charge-transport blocks is a polyarylene residue.

11. The polymeric adsorption film according to any of Claims 1 to 3, wherein at least one of the charge-transport blocks

is an aromatic polyamine residue.

**12.** The polymeric adsorption film according to Claim 11, wherein a concentration by weight of a nitrogen atom contained in the polymer is 1% or more.

**13.** The polymeric adsorption film according to any of Claims 1 to 3, wherein at least one of the charge-transport blocks is a polyarylene residue and at least one of the charge-transport blocks is an aromatic polyamine residue.

**14.** The polymeric adsorption film according to Claim 10, wherein the polyarylene residue is a polyfluorene-diyl group which may have a substituent or a polybenzofluorene-diyl group which may have a substituent.

**15.** The polymeric adsorption film according to Claim 9, wherein the asymmetric block copolymer comprises a segment (A) comprising one or two or more hole-transport blocks and a segment (B) comprising one or two or more electron-transport blocks which are directly or indirectly linked to the segment (A).

**16.** The polymeric adsorption film according to Claim 9, wherein the asymmetric block copolymer has a structure represented by the following formula (1):

$$\cdots\left(\cdots Ar^{11}\cdots\right)_{m^{11}}\cdots\left(\cdots Ar^{12}\cdots\right)_{m^{12}}\cdots\left(\cdots Ar^{13}\cdots\right)_{m^{13}}\cdots\ \cdots\ \cdots\left(\cdots Ar^{n}\cdots\right)_{m^{n}}\cdots \quad (1)$$

wherein $Ar^{11}$, $Ar^{12}$, $Ar^{13}$,..., and $Ar^{n}$ (n is an integer of 12 or more) each independently represent a divalent conjugated group which may have a substituent in one charge-transport block, provided that the charge-transport blocks may be directly bonded together or may be bonded via a bonding group, and when the charge-transport blocks are directly bonded together, the divalent conjugated group constituting two charge-transport blocks which are directly bonded are different each other; $m^{11}$, $m^{12}$, $m^{13}$,..., $m^{n}$ are each independently an integer of 5 or more.

**17.** The polymeric adsorption film according to Claim 16, wherein the asymmetric block copolymer is represented by the following formula (6):

$$R^{X}-\left(Ar^{1}\right)_{m^{1}}-\left(Ar^{2}\right)_{m^{2}}-\left(Ar^{3}\right)_{m^{3}}-R^{Y} \quad (6)$$

wherein $Ar^1$, $Ar^2$ and $Ar^3$ each independently represent a divalent conjugated group which may have a substituent, provided that $Ar^1$ and $Ar^2$ are different and $Ar^2$ and $Ar^3$ are different; $R^X$ and $R^Y$ each independently represent a terminal group; $m^1$, $m^2$ and $m^3$ are each independently an integer of 0 or more, provided that at least two of $m^1$, $m^2$ and $m^3$ are an integer of 5 or more; when $Ar^2$ has an adhesion group, $R^X$, $R^Y$, $Ar^1$ and $Ar^3$ have no adhesion groups; when $Ar^2$ has no adhesion groups, either one of $Ar^1$ or $R^X$ and either one of $Ar^3$ or $R^Y$ have an adhesion group.

**18.** The polymeric adsorption film according to Claim 17, wherein the asymmetric block copolymer is represented by the following formula (7):

$$R^{P}-\left(Ar^{4}\right)_{m^{4}}-\left(Ar^{5}\right)_{m^{5}}-R^{Q} \quad (7)$$

wherein $Ar^4$ and $Ar^5$ each independently represent a divalent conjugated group which may have a substituent, provided that $Ar^4$ and $Ar^5$ are different; $R^P$ and $R^Q$ each independently represent a terminal group; $m^4$ and $m^5$ each independently are an integer of 5 or more; $Ar^4$, $R^P$, $Ar^5$ or $R^Q$ has an adhesion group.

**19.** The polymeric adsorption film according to Claim 18, wherein the $Ar^4$ is a polyarylene residue which may have a substituent and the $Ar^5$ is an aromatic polyamine residue which may have a substituent.

20. The polymeric adsorption film according to Claim 19, wherein the polyarylene residue is a polyfluorene-diyl group which may have a substituent or a polybenzofluorene-diyl group which may have a substituent.

21. A process for producing the polymeric adsorption film according to any of Claims 1 to 3 comprising a step of immersing the substrate in a solution of the polymer.

22. A process for producing the polymeric adsorption film according to any of Claims 1 to 3 comprising a step of applying a solution of the polymer to the substrate.

23. A process for producing the polymeric adsorption film according to any of Claims 1 to 3-comprising a step of immersing or applying a solution of the polymer to the substrate and then bringing the polymer into contact with a good solvent of the polymer.

24. A polymeric adsorption film obtained by the process for producing a polymeric adsorption film according to Claim 21.

25. A polymeric adsorption film obtained by the process for producing a polymeric adsorption film according to Claim 22.

26. A polymeric adsorption film obtained by the process for producing a polymeric adsorption film according to Claim 23.

27. An electronic device comprising the polymeric adsorption film according to any of Claims 1 to 3.

28. A light-emitting diode comprising the electronic device according to Claim 27.

29. A photoelectric conversion device comprising the electronic device according to Claim 27.

Fig.1

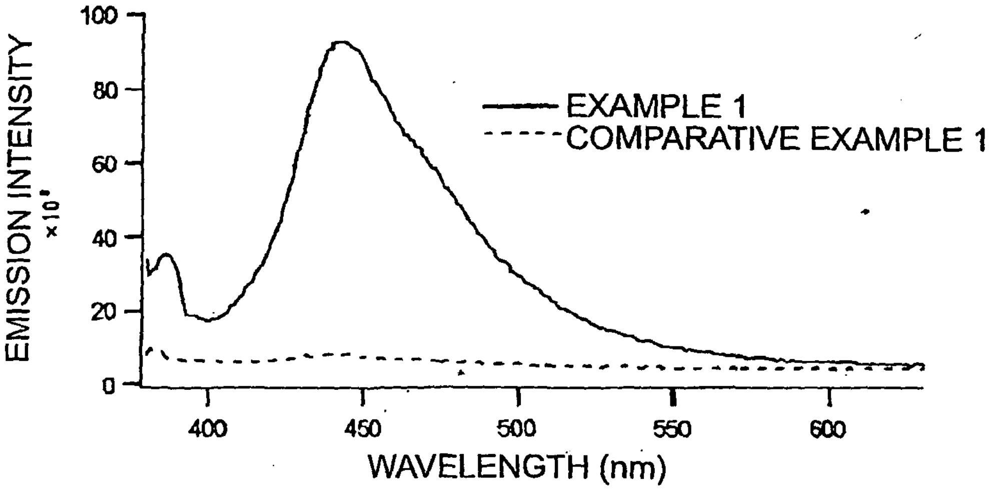
EMISSION INTENSITY
×10⁴
100
80
60
40
20
0
400
450
500
550
600
WAVELENGTH (nm)
EXAMPLE 1
COMPARATIVE EXAMPLE 1

Fig.2

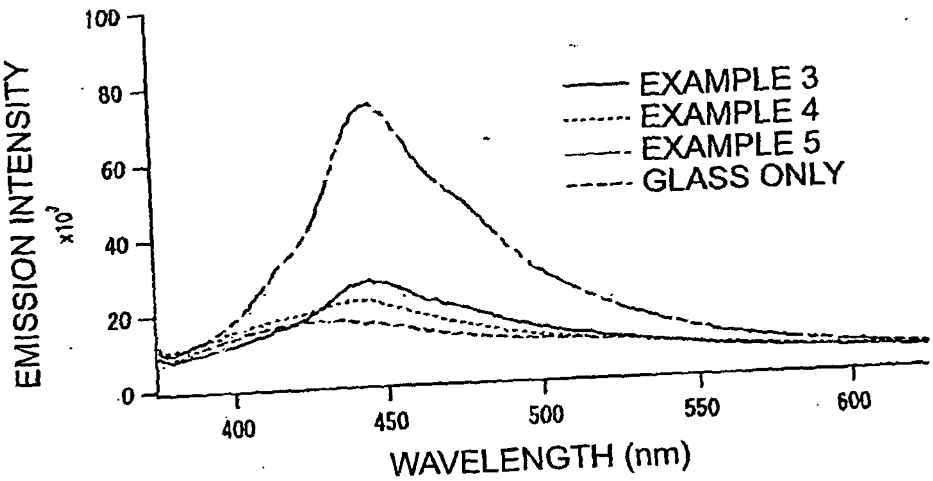

100
80
60
40
20
0
EMISSION INTENSITY x10^3
400
450
500
550
600
WAVELENGTH (nm)
EXAMPLE 3
EXAMPLE 4
EXAMPLE 5
GLASS ONLY

**INTERNATIONAL SEARCH REPORT**

International application No.
PCT/JP2007/069138

A. CLASSIFICATION OF SUBJECT MATTER
*C09K11/06*(2006.01)i, *C08G61/00*(2006.01)i, *H01L33/00*(2006.01)i, *H01L51/42*(2006.01)i

According to International Patent Classification (IPC) or to both national classification and IPC

B. FIELDS SEARCHED

Minimum documentation searched (classification system followed by classification symbols)
C09K11/06, C08G61/00, H01L33/00, H01L51/42

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)
CA(STN)

C. DOCUMENTS CONSIDERED TO BE RELEVANT

| Category* | Citation of document, with indication, where appropriate, of the relevant passages | Relevant to claim No. |
|---|---|---|
| X<br>A | JP 2002-539292 A (Cambridge Display Technology Ltd.),<br>19 November, 2002 (19.11.02),<br>& US 2003/0153725 A1 & EP 1672719 A2<br>& WO 2000/055927 A1 | 1-3,21-29<br>4-20 |
| X<br>A | JP 2002-507825 A (Cambridge Display Technology Ltd.),<br>12 March, 2002 (12.03.02),<br>& US 2004/0075381 A1 & EP 1672719 A2<br>& WO 1999/048160 A1 | 1-3,21-29<br>4-20 |
| A | JP 2006-169265 A (Sumitomo Chemical Co., Ltd.),<br>29 June, 2006 (29.06.06),<br>& WO 2005/056633 A1 | 1-29 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
31 October, 2007 (31.10.07)

Date of mailing of the international search report
13 November, 2007 (13.11.07)

Name and mailing address of the ISA/
Japanese Patent Office

Facsimile No.

Authorized officer

Telephone No.

Form PCT/ISA/210 (second sheet) (April 2007)

**INTERNATIONAL SEARCH REPORT**

International application No.
PCT/JP2007/069138

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-339190 A (Samsung SDI Co., Ltd.), 02 December, 2004 (02.12.04), & US 2004/0147701 A1 & EP 1443093 A1 | 1-29 |
| A | JP 2006-252813 A (JSR Corp.), 21 September, 2006 (21.09.06), (Family: none) | 1-29 |
| A | JP 2006-032689 A (Sharp Corp.), 02 February, 2006 (02.02.06), (Family: none) | 1-29 |
| P,X | JP 2007-211237 A (Sumitomo Chemical Co., Ltd.), 23 August, 2007 (23.08.07), & WO 2007/074920 A1 | 1-29 |

Form PCT/ISA/210 (continuation of second sheet) (April 2007)

**INTERNATIONAL SEARCH REPORT**

International application No.
PCT/JP2007/069138

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☒ Claims Nos.: part of 4-20
because they relate to parts of the international application that do not comply with the prescribed requirements to such an extent that no meaningful international search can be carried out, specifically:
See extra sheet.

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

INTERNATIONAL SEARCH REPORT

International application No.
PCT/JP2007/069138

Continuation of Box No.II-2 of continuation of first sheet(2)

Claims 1-29

The "polymeric adsorption films" of the claims are unclear as to what structure the "polymer comprising charge-transporting blocks" in each film has.

With respect to the "polymeric adsorption films" of the claims, in which the "polymer comprising charge-transporting blocks" is preferentially adherent to the base surface, it is unclear from the statements in the description as to what structure the polymer in each film, other than the polymers shown in Examples, has. The acquisition of a polymeric adsorption film having that property necessitates trials and errors which are above a level expected of persons skilled in the art. In particular, such polymer satisfying the "formula" given in claim 5 is not shown even in the Examples.

Therefore, it is not considered that the claims are clearly described. The claims are neither sufficiently supported by the description nor clearly and sufficiently disclosed therein in such a degree that persons skilled in the art can practice them.

With respect to claims 4-20, no search was made for the subject matter which is neither clearly described in the claims, nor sufficiently supported by the description, nor clearly and sufficiently disclosed in the description. Namely, no search was made for the subject matter other than the "polymeric adsorption films" including the polymers shown in the Examples.

Claims 1-29

The claims are not clearly described in the following points.

(1) Whether the "polymeric adsorption film" in claims 1-3 includes a "base" besides the polymer is unclear.

(2) What the term "surface of a base" in claims 1 and 2 means is unclear.

(3) What the terms "adsorption" and "exposed" in the claims mean is unclear. Although these terms are defined in the description, the meanings thereof are unclear.

(4) It is unclear as to what property of the polymeric adsorption film is defined by the "formulae" given in claims 4 and 5. It is unclear as to why the property of the polymeric adsorption film can be defined by these formulae.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6169163 B
- JP 2006032689 A

### Non-patent literature cited in the description

- *Chemical Physics Letters,* vol. 29 (2), 277-283
- *Journal of American Chemical Society,* vol. 124, 11862-11863